# EUROPEAN PATENT APPLICATION

(11) **EP 2 520 632 A2**
(43) Date of publication of application: **07.11.2012**
(21) Application number: 10841123.2
(22) Date of filing: 04.11.2010
(51) Int. Cl.: C09K 11/06, H01L 51/50

(54) **COMPOUND FOR ORGANIC PHOTOELECTRIC DEVICE AND ORGANIC PHOTOELECTRIC DEVICE INCLUDING THE COMPOUND**

(30) Priority: 31.12.2009 KR 20090136182
(71) Applicant: Cheil Industries Inc., Kumi-city, Kyungsangbuk-do 730-030 (KR)
(72) Inventor: JUNG, Ho-Kuk, Uiwang-si Gyeonggi-do 437-711 (KR); KANG, Dong-Min, Uiwang-si Gyeonggi-do 437-711 (KR); IN, Kyu-Yeol, Uiwang-si Gyeonggi-do 437-711 (KR); KIM, Nam-Soo, Uiwang-si Gyeonggi-do 437-711 (KR); JUNG, Sung-Hyun, Uiwang-si Gyeonggi-do 437-711 (KR); KANG, Myeong-Soon, Uiwang-si Gyeonggi-do 437-711 (KR); LEE, Nam-Heon, Uiwang-si Gyeonggi-do 437-711 (KR); KANG, Eui-Su, Uiwang-si Gyeonggi-do 437-711 (KR); CHAE, Mi-Young, Uiwang-si Gyeonggi-do 437-711 (KR)
(74) Representative: Michalski, Stefan
(86) International application number: PCT/KR2010/007763
(87) International publication number: WO 2011/081290

(57) **Abstract**

Disclosed are a compound for an organic photoelectric device and an organic photoelectric device including the same, wherein the compound for an organic photoelectric device is represented by Chemical Formula 1.

The above Chemical Formula 1 is the same as defined in the specification. Using the compound for an organic photoelectric device, an organic photoelectric device having excellent thermal/electrochemical stability and life-span, and efficiency is realized.

## Description

### CROSS-REFERENCE TO RELATED APPLICATION

This application claims priority to and the benefit of Korean Patent Application No. 10-2009-0136182 filed in the Korean Intellectual Property Office on December 31, 2009, the entire contents of which are incorporated herein by reference.

### BACKGROUND OF THE INVENTION

### (a) Field of the Invention

A compound for an organic photoelectric device being capable of providing an organic photoelectric device having excellent life-span, efficiency, electrochemical stability, and thermal stability, and an organic photoelectric device including the same are related.

### (b) Description of the Related Art

An organic photoelectric device is, in a broad sense, a device for transforming photo-energy to electrical energy, or conversely, a device for transforming electrical energy to photo-energy.

An organic photoelectric device may be classified into two as follows in accordance with its driving principle. A organic photoelectric device is an electron device driven as follows: excitons are generated in an organic material layer by photons entering a device from an external light source; the excitons are separated into electrons and holes; and the electrons and holes are respectively transferred to different electrodes and used as a current source (a voltage source).

A second organic photoelectric device is an electron device driven as follows: a voltage or a current is applied to at least two electrodes to inject holes and/or electrons into an organic material semiconductor positioned on an interface of the electrodes; and the injected electrons and holes drives the device.

Examples of the organic photoelectric devices include an organic photoelectric device, an organic solar cell, an organic photo conductor drum, an organic transistor, and the like and require a hole injecting or transporting material, an electron injecting or transporting material, or a light emitting material.

Particularly, an organic photoelectric device (an organic light emitting diode, OLED) has recently drawn attention due to an increasing demand for a flat panel display. In general, organic light emission refers to transformation of electrical energy to photo-energy.

Such an organic photoelectric device transforms electrical energy into light by applying a current to an organic light emitting material and has a structure that a functional organic material layer is interposed between an anode and a cathode. The organic material layer includes a multi-layer respectively including different materials, for example, a hole injection layer (HIL), a hole transport layer (HTL), an emission layer, an electron transport layer (ETL), and an electron injection layer (EIL) in order to improve efficiency and stability of an organic photoelectric device.

In such an organic photoelectric device, when a voltage is applied between an anode and a cathode, holes from the anode and electrons from the cathode are injected to an organic material layer and recombined to generate excitons having high energy. The generated excitons generate a light having a certain wavelength while shifting to a ground state.

In 1987, Eastman Kodak, Inc. firstly developed an organic light emitting diode including a low molecular aromatic diamine and aluminum complex as an emission layer forming material (Applied Physics Letters. 51, 913, 1987). C.W Tang et al. firstly disclosed a practicable device as an organic light emitting diode in 1987 (Applied Physics Letters, 51 12, 913-915, 1987).

According to the reference, the organic layer has a structure that a diamine derivative thin film (hole transport layer (HTL)) and a tris(8-hydroxy-quinolate)aluminum (Alq₃) thin film are laminated.

Recently, a phosphorescent light emitting material as well as a fluorescent light emitting material has become known to be used for a light emitting material of an organic light emitting diode (D. F. O'Brien et al., Applied Physics Letters, 74(3), 442-444, 1999; M. A. Baldo et al., Applied Physics letters, 75(1), 4-6, 1999). Such a phosphorescent material emits lights by transiting electrons from a ground state to an exited state, non-radiance transiting a singlet exciton to a triplet exciton through intersystem crossing, and transiting a triplet exciton to a ground state to emit a light.

As described above, in an organic light emitting diode, an organic material layer includes a light emitting material and a charge transport material, for example, a hole injection material, a hole transport material, an electron transport material, an electron injection material, and so on.

The light emitting material is classified as blue, green, and red light emitting materials according to emitted colors and yellow and orange light emitting materials to emit colors approaching natural colors.

Since one light emitting material has a maximum light emitting wavelength shifted to a long wavelength and decrease color purity because of interactions among molecules or deteriorate device efficiency because of light emitting quenching effects, a host/dopant system may be used therewith in order to improve color purity and increase luminous efficiency and stability through energy transfer.

In order to implement the aforementioned excellent performances of an organic photoelectric device, a material constituting an organic material layer, for example, a hole injection material, a hole transport material, a light emitting material, an electron transport material, an electron injection material, and a light emitting material such as a host and/or a dopant, should be first supported by a stable and efficient material. However, development of a material for an organic material layer for an organic light emitting diode has far not been satisfactory, and thus, there is a need for a novel material. This development of a novel material is also required for other organic photoelectric devices.

### SUMMARY OF THE INVENTION

A compound for an organic photoelectric device that may act as a electron injection and/or transport material and also, as a light emitting host along with an appropriate dopant is provided.

An organic photoelectric device having excellent life span, efficiency, driving voltage, electrochemical stability, and thermal stability is provided.

According to one aspect of the present invention, a compound for an organic photoelectric device represented by the following Chemical Formula 1 is provided.

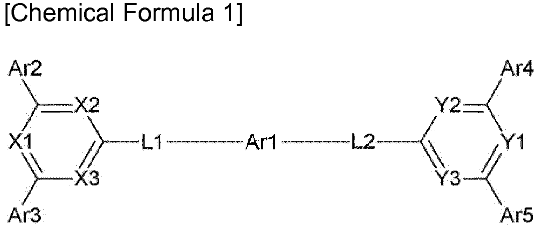

In Chemical Formula 1, Ar1 is a substituted or unsubstituted C2 to C30 heteroaryl group, Ar2 to Ar5 are the same or different and independently a substituted or unsubstituted C6 to C30 aryl group, L1 and L2 are the same or different and independently a substituted or unsubstituted C6 to C30 arylene group, X1 to X3 are the same or different and independently a heteroatom or C-H, provided that at least one of X1 to X3 is a heteroatom, Y1 to Y3 are the same or different and independently a heteroatom or C-H, provided that at least one of Y1 to Y3 is a heteroatom.

According to one exemplary embodiment, Ar1 may be selected from the group consisting of a substituted or unsubstituted imidazolylene group, a substituted or unsubstituted thiazolylene group, a substituted or unsubstituted oxazolylene group, a substituted or unsubstituted oxadiazolylene group, a substituted or unsubstituted triazolylene group, a substituted or unsubstituted pyrimidinylene group, a substituted or unsubstituted pyridinylene group, a substituted or unsubstituted pyradazinylene group, a substituted or unsubstituted quinolinylene group, a substituted or unsubstituted isoquinolinylene group, a substituted or unsubstituted acridinylene group, a substituted or unsubstituted imidazopyridinylene group, and a substituted or unsubstituted imidazopyrimidinylene group.

According to one exemplary embodiment, Ar1 may be a substituent selected from the group consisting of the following Chemical Formulae 2 to 7.

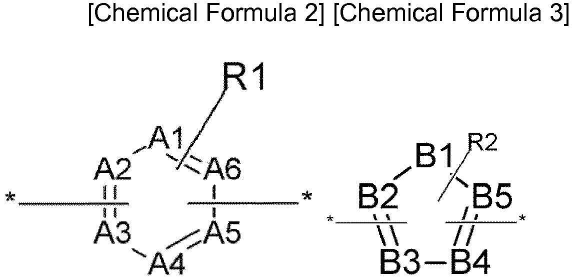

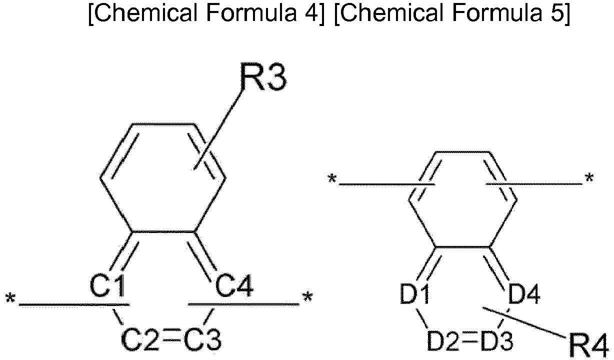

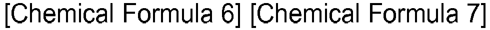

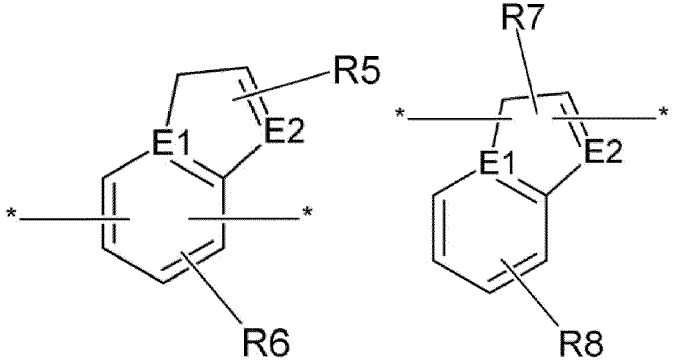

In Chemical Formulae 2 to 7, A1 to A6 are the same or different and independently a heteroatom or C-H, provided that at least one of A1 to A6 is a heteroatom, B1 to B5 are the same or different and are independently a heteroatom or C-H, provided that at least one of B1 to B5 is a heteroatom, C1 to C4 are the same or different and are independently a heteroatom or C-H, provided that at least one of C1 to C4 is a heteroatom, D1 to D4 are the same or different and are independently a heteroatom or C-H, provided that at least one of D1 to D4 is a heteroatom, E1 and E2 are the same or different and are independently a heteroatom or C-H, provided that at least one of E1 and E2 is a heteroatom, and R1 to R7 are the same or different and are independently selected from the group consisting of hydrogen, a substituted or unsubstituted C1 to C10 alkyl group, a substituted or unsubstituted C5 to C30 aryl group, and a substituted or unsubstituted C2 to C30 heteroaryl group.

According to one exemplary embodiment, Ar2 to Ar5 are the same or different and independently selected from the group consisting of a substituted or unsubstituted phenyl group, a substituted or unsubstituted naphthyl group, a substituted or unsubstituted anthracenyl group, a substituted or unsubstituted phenanthrenyl group, a substituted or unsubstituted pyrenyl group, a substituted or unsubstituted perylenyl group, and a substituted or unsubstituted chrysenyl group.

According to one exemplary embodiment, L1 and L2 are the same or different and independently selected from the group consisting of a substituted or unsubstituted phenylene group, a substituted or unsubstituted naphthylene group, a substituted or unsubstituted anthracenylene group, a substituted or unsubstituted phenanthrenylene group, a substituted or unsubstituted pyrenylene group, a substituted or unsubstituted perylenylene group, and a substituted or unsubstituted chrysenylene group.

According to another aspect of the present invention, provided is an organic photoelectric device that includes an anode, a cathode, and at least one or more organic thin layers between the anode and the cathode, wherein at least one of the organic thin layer includes the compound for an organic photoelectric device.

The organic thin layer may be selected from the group consisting of an emission layer, a hole transport layer (HTL), a hole injection layer (HIL), an electron transport layer (ETL), an electron injection layer (EIL), a hole blocking layer, and a combination thereof.

The compound for an organic photoelectric device may be included in an electron transport layer (ETL) or an electron injection layer (EIL).

The compound for an organic photoelectric device may be included in an emission layer.

The compound for an organic photoelectric device may be used as a phosphorescent or fluorescent host material in an emission layer.

The compound for an organic photoelectric device may be used as a fluorescent blue dopant material in an emission layer.

The organic photoelectric device may be selected from the group consisting of an organic light emitting diode, an organic solar cell, an organic transistor, an organic photo conductor drum, and an organic memory device.

According to another aspect of the present invention, a display device including the organic photoelectric device is provided.

An organic photoelectric device having life-span characteristic and high luminous efficiency at a low driving voltage may be provided due to excellent electrochemical and thermal stability.

### BRIEF DESCRIPTION OF THE DRAWINGS

FIGS. 1 to 5 are cross-sectional views showing organic photoelectric devices including compounds for an organic photoelectric device according to various embodiments of the present invention.
FIG. 6 shows current density changes depending on voltage change according to Examples of the present invention and Comparative Example.
FIG. 7 shows luminance changes depending on voltage change according to Examples of the present invention and Comparative Example.
FIG. 8 shows luminous efficiency experimental data according to Examples of the present invention and Comparative Example.
FIG. 9 shows electric power efficiency experimental data according to Examples of the present invention and Comparative Example.
FIG. 10 shows life-span measurements and experimental data of the organic photoelectric devices according to Examples of the present invention and Comparative Example.

### <Description of Reference Numerals Indicating Primary Elements in the Drawings>

| | |
|---|---|
| 100: organic photoelectric device | 110: cathode |
| 120: anode | 105: organic thin layer |
| 130: emission layer | 140: hole transport layer (HTL) |
| 150: electron transport layer (ETL) | 160: electron injection layer (EIL) |
| 170: hole injection layer (HIL) | 230: emission layer + electron transport layer (ETL) |

### DETAILED DESCRIPTION

Exemplary embodiments of the present invention will hereinafter be described in detail. However, these embodiments are only exemplary, and the present invention is not limited thereto.

Through the specification, the term "substituted" refers to one substituted with a C1 to C30 alkyl group, a C1 to C10 alkylsilyl group, a C3 to C30 cycloalkyl group, a C6 to C30 aryl group, a C1 to C10 alkoxy group, a fluoro group, a C1 to C10 trifluoroalkyl group such as a trifluoromethyl group, and the like, or a cyano group.

Through the specification, the term "hetero" refers to one including 1 to 3 heteroatoms selected from the group consisting of N, O, S, and P and carbons in the rest thereof, in one ring.

Through the specification, the term "a combination thereof" refers to at least two substituents bound to each other by a linker or at least two substituents fused to each other.

Through the specification, when a definition is not otherwise provided, the term "alkyl" refers to an aliphatic hydrocarbon group. The alkyl may be a "saturated alkyl group" that does not include any alkene or alkyne. Alternatively, the alkyl may be an "unsaturated alkyl group" that includes at least one alkene or alkyne. The term "alkene" refers to a group in which at least two carbon atoms are bound in at least one carbon-carbon double bond, and the term "alkyne" refers to a group in which at least two carbon atoms are bound in at least one carbon-carbon triple bond. Regardless of being saturated or unsaturated, the alkyl may be branched, linear, or cyclic.

The alkyl group may have 1 to 20 carbon atoms. The alkyl group may be a medium-sized alkyl having 1 to 10 carbon atoms. The alkyl group may be a lower alkyl having 1 to 6 carbon atoms.

For example, a C1 to C4 alkyl may have 1 to 4 carbon atoms and may be selected from the group consisting of methyl, ethyl, propyl, iso-propyl, n-butyl, iso-butyl, sec-butyl, and t-butyl.

Examples of an alkyl group may be selected from the group consisting of methyl, ethyl, propyl, isopropyl, butyl, isobutyl, t-butyl, pentyl, hexyl, ethenyl, propenyl, butenyl, cyclopropyl, cyclobutyl, cyclopentyl, cyclohexyl, or the like, which may be individually and independently substituted.

The term "aryl" refers to an aryl group including a carbocyclic aryl (e.g., phenyl) having at least one ring having a covalent pi electron system. The term also refers to monocyclic or fused polycyclic (i.e., rings sharing adjacent pairs of carbon atoms) groups. In addition, this term also refers to a spiro compound having a contact point of one carbon.

The term "heteroaryl" refers to a heterocyclic aryl group including a carbocyclic aryl (e.g., pyridine) having at least one ring having a covalent pi electron system. The term also refers to monocyclic or fusion ring polycyclic (i.e., groups sharing adjacent pairs of carbon atoms) groups. In addition, the term also refers to a spiro compound having a contact point of one carbon.

According to one embodiment of the present invention, a compound for an organic photoelectric device may have a structure that a substituent represented by at least two "*-arylene group-heteroaryl groups" is combined with the core of a heteroarylene group. In the specification, "*" marks where a substituent is combined.

In addition, the compound for an organic photoelectric device may have a core structure and include various substituents for the two substituents and thus, various energy band gaps and therefore, satisfy conditions required for an emission layer as well as an electron injection layer (EIL) and an electron transfer layer.

When the compound having appropriate energy levels due to substituents is used for an organic photoelectric device, electron transfer capability may be reinforced and thus, excellent efficiency and driving voltage and excellent electrochemical and thermal stability may be improved resulting in improvement of life-span characteristics of the organic photoelectric device.

According to one embodiment of the present invention, a compound for an organic photoelectric device represented by the following Chemical Formula 1 is provided.

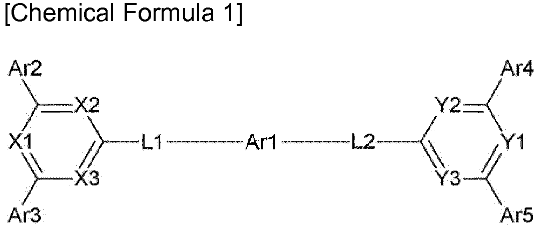

In Chemical Formula 1, Ar1 is a substituted or unsubstituted C2 to C30 heteroaryl group. For example, Ar1 is selected from the group consisting of a substituted or unsubstituted imidazolylene group, a substituted or unsubstituted thiazolylene group, a substituted or unsubstituted oxazolylene group, a substituted or unsubstituted oxadiazolylene group, a substituted or unsubstituted triazolylene group, a substituted or unsubstituted pyrimidinylene group, a substituted or unsubstituted pyridinylene group, a substituted or unsubstituted pyradazinylene group, a substituted or unsubstituted quinolinylene group, a substituted or unsubstituted isoquinolinylene group, a substituted or unsubstituted acridinylene group, a substituted or unsubstituted imidazopyridinylene group, and substituted or unsubstituted imidazopyrimidinylene group.

Specific examples of Ar1 may be a substituent selected from the group consisting of the following Chemical Formulae 2 to 7.

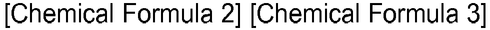

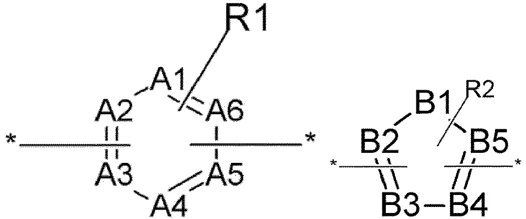

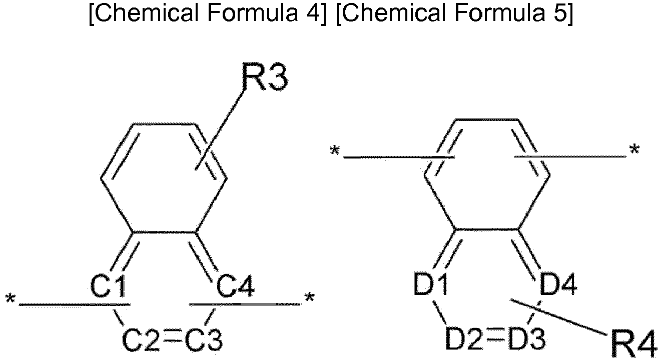

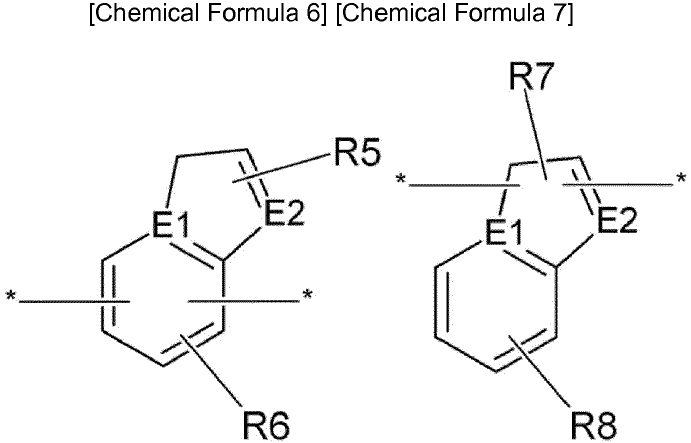

In Chemical Formulae 2 to 7, A1 to A6 are the same or different and are independently a heteroatom or C-H, provided that at least one of A1 to A6 is a heteroatom, B1 to B5 are the same or different and are independently a heteroatom or C-H, provided that at least one of B1 to B5 is a heteroatom, C1 to C4 are the same or different and are independently a heteroatom or C-H, provided that at least one of C1 to C4 is a heteroatom, D1 to D4 are the same or different and are independently a heteroatom or C-H, provided that at least one of D1 to D4 is a heteroatom, E1 and E2 are the same or different and are independently a heteroatom or C-H, provided that at least one of E1 and E2 is a heteroatom, and R1 to R7 are the same or different and are independently selected from the group consisting of hydrogen, a substituted or unsubstituted C1 to C10 alkyl group, a substituted or unsubstituted C5 to C30 aryl group, and a substituted or unsubstituted C2 to C30 heteroaryl group.

The Ar1 is the core of the aforementioned heteroarylene group. As shown in Chemical Formula 1, L1 and L2 may be combined with the core.

L1 and L2 are the same or different and independently a substituted or unsubstituted C6 to C30 arylene group. For example, L1 and L2 are the same or different and are independently selected from the group consisting of a substituted or unsubstituted phenylene group, a substituted or unsubstituted naphthylene group, a substituted or unsubstituted anthracenylene group, a substituted or unsubstituted phenanthrenylene group, a substituted or unsubstituted pyrenylene group, a substituted or unsubstituted perylenyl group, and a substituted or unsubstituted chrysenylene group.

The L1 and L2 may be adjusted aboutπ-conjugation length to control light emission in a visible region. Accordingly, the compound may be usefully applied to an emission layer for an organic photoelectric device. However, when the number of carbons is out of the aforementioned range, the compound may not have sufficient effects on a device.

When the compound is used to form an emission layer, a compound with the number of carbon of less than 6 may have inappropriate conjugation while a compound with the number of carbon more than 30 may inappropriately shift light-emitting colors toward an infrared region.

In addition, even when the compound forms an electron transport layer (ETL), a compound having the number of carbon of less than 6 may have inappropriate conjugation, while a compound having the number of carbon of less than 30 may decrease a band gap and deteriorate capability of inhibiting a hole.

As shown in Chemical Formula 1, a heteroaryl group may be independently combined with the L1 and L2.

In Chemical Formula 1, X1 to X3 are the same or different and independently a heteroatom or C-H, provided that at least one of X1 to X3 is a heteroatom, Y1 to Y3 are the same or different and are independently a heteroatom or C-H, provided that at least one of Y1 to Y3 is a heteroatom.

When the compound has a structure of combining the substituent, it may have excellent thermal stability due to hydrogen bonds of hetero atoms, improving life-span characteristics of an organic photoelectric device.

In addition, Ar2 to Ar5, which are substituents combined with heteroaryl groups at the end, are the same or different and independently a substituted or unsubstituted C6 to C30 aryl group. For example, Ar2 to Ar5 are the same or different and are independently selected from the group consisting of a substituted or unsubstituted phenyl group, a substituted or unsubstituted naphthyl group, a substituted or unsubstituted anthracenyl group, a substituted or unsubstituted phenanthrenyl group, a substituted or unsubstituted pyrenyl group, a substituted or unsubstituted perylenyl group, a substituted or unsubstituted chrysenyl group.

The Ar2 to Ar5 may adjust various electron transfer capabilities of a compound. In addition, crystallinity of the compound may be adjusted, accomplishing long life-span of a device.

The compound for an organic photoelectric device may be represented by the following Chemical Formulae 8 to 18. However, the present invention is not limited to the following compounds. The combination of the compounds may be represented by the following compounds 1 to 385.

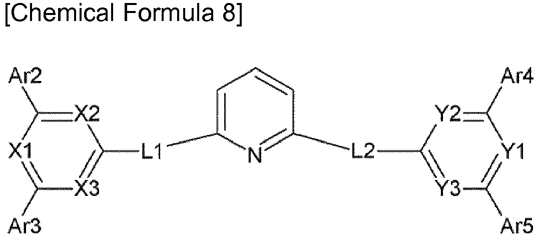

In Chemical Formula 8, Ar2 to Ar5, X1 to X3, Y1 to Y3, L1, and L2 are the same as defined in the following Table 1.

**(Table 1)**

| Compound | Ar2 and Ar4 | Ar3 and Ar5 | L1 and L2 | X1 and Y1 | X2 and Y2 | X3 and Y3 |
|---|---|---|---|---|---|---|
| 1 | 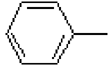 | 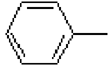 | 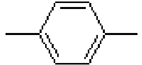 | N | C | C |
| 2 | | | | C | N | C |
| 3 | | | | C | C | N |
| 4 | | | | N | N | C |
| 5 | | | | N | C | N |
| 6 | | | | C | N | N |
| 7 | | | | N | N | N |
| 8 | 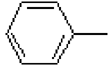 | 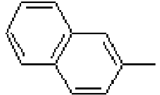 | 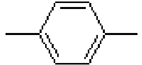 | N | C | C |
| 9 | | | | C | N | C |
| 10 | | | | C | C | N |
| 11 | | | | N | N | C |
| 12 | | | | N | C | N |
| 13 | | | | C | N | N |
| 14 | | | | N | N | N |
| 15 | 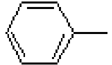 | 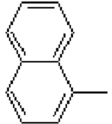 | 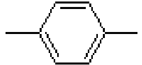 | N | C | C |
| 16 | | | | C | N | C |
| 17 | | | | C | C | N |
| 18 | | | | N | N | C |
| 19 | | | | N | C | N |
| 20 | | | | C | N | N |
| 21 | | | | N | N | N |
| 22 | 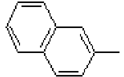 | 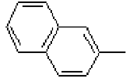 | 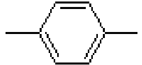 | N | C | C |
| 23 | | | | C | N | C |
| 24 | | | | C | C | N |
| 25 | | | | N | N | C |
| 26 | | | | N | C | N |
| 27 | | | | C | N | N |
| 28 | | | | N | N | N |
| 29 | 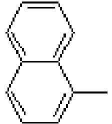 | 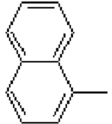 | 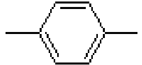 | N | C | C |
| 30 | | | | C | N | C |
| 31 | | | | C | C | N |
| 32 | | | | N | N | C |
| 33 | | | | N | C | N |
| 34 | | | | C | N | N |
| 35 | | | | N | N | N |

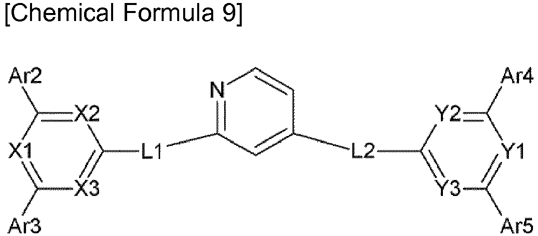

In Chemical Formula 9, Ar2 to Ar5, X1 to X3, Y1 to Y3, L1, and L2 are the same as defined in the following Table 2.

**(Table 2)**

| Compound | Ar2 and Ar4 | Ar3 and Ar5 | L1 and L2 | X1 and Y1 | X2 and Y2 | X3 and Y3 |
|---|---|---|---|---|---|---|
| 36 | 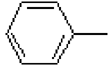 | 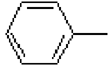 | 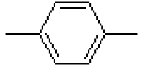 | N | C | C |
| 37 | | | | C | N | C |
| 38 | | | | C | C | N |
| 39 | | | | N | N | C |
| 40 | | | | N | C | N |
| 41 | | | | C | N | N |
| 42 | | | | N | N | N |
| 43 | 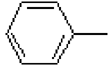 | 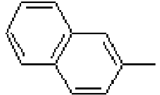 | 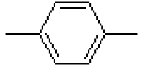 | N | C | C |
| 44 | | | | C | N | C |
| 45 | | | | C | C | N |
| 46 | | | | N | N | C |
| 47 | | | | N | C | N |
| 48 | | | | C | N | N |
| 49 | | | | N | N | N |
| 50 | 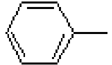 | 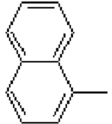 | 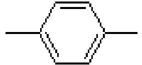 | N | C | C |
| 51 | | | | C | N | C |
| 52 | | | | C | C | N |
| 53 | | | | N | N | C |
| 54 | | | | N | C | N |
| 55 | | | | C | N | N |
| 56 | | | | N | N | N |
| 57 | 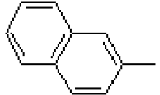 | 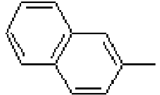 | 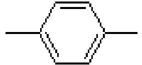 | N | C | C |
| 58 | | | | C | N | C |
| 59 | | | | C | C | N |
| 60 | | | | N | N | C |
| 61 | | | | N | C | N |
| 62 | | | | C | N | N |
| 63 | | | | N | N | N |
| 64 | 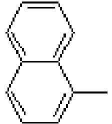 | 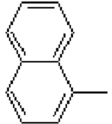 | 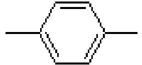 | N | C | C |
| 65 | | | | C | N | C |
| 66 | | | | C | C | N |
| 67 | | | | N | N | C |
| 68 | | | | N | C | N |
| 69 | | | | C | N | N |
| 70 | | | | N | N | N |

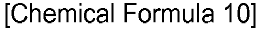

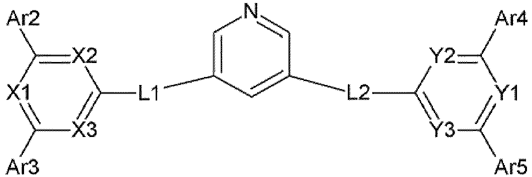

In Chemical Formula 10, Ar2 to Ar5, X1 to X3, Y1 to Y3, L1, and L2 are the same as defined in the following Table 3.

**(Table 3)**

| Compound | Ar2 and Ar4 | Ar3 and Ar5 | L1 and L2 | X1 and Y1 | X2 and Y2 | X3 and Y3 |
|---|---|---|---|---|---|---|
| 71 | 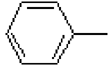 | 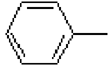 | 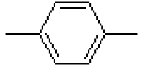 | N | C | C |
| 72 | | | | C | N | C |
| 73 | | | | C | C | N |
| 74 | | | | N | N | C |
| 75 | | | | N | C | N |
| 76 | | | | C | N | N |
| 77 | | | | N | N | N |
| 78 | 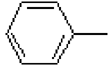 | 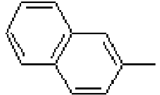 | 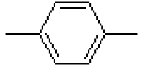 | N | C | C |
| 79 | | | | C | N | C |
| 80 | | | | C | C | N |
| 81 | | | | N | N | C |
| 82 | | | | N | C | N |
| 83 | | | | C | N | N |
| 84 | | | | N | N | N |
| 85 | 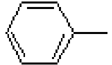 | 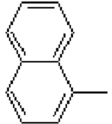 | 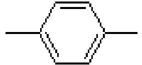 | N | C | C |
| 86 | | | | C | N | C |
| 87 | | | | C | C | N |
| 88 | | | | N | N | C |
| 89 | | | | N | C | N |
| 90 | | | | C | N | N |
| 91 | | | | N | N | N |
| 92 | 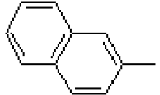 | 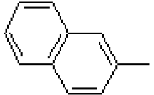 | 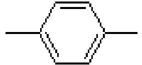 | N | C | C |
| 93 | | | | C | N | C |
| 94 | | | | C | C | N |
| 95 | | | | N | N | C |
| 96 | | | | N | C | N |
| 97 | | | | C | N | N |
| 98 | | | | N | N | N |
| 99 | 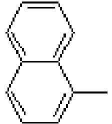 | 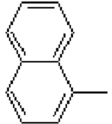 | 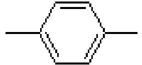 | N | C | C |
| 100 | | | | C | N | C |
| 101 | | | | C | C | N |
| 102 | | | | N | N | C |
| 103 | | | | N | C | N |
| 104 | | | | C | N | N |
| 105 | | | | N | N | N |

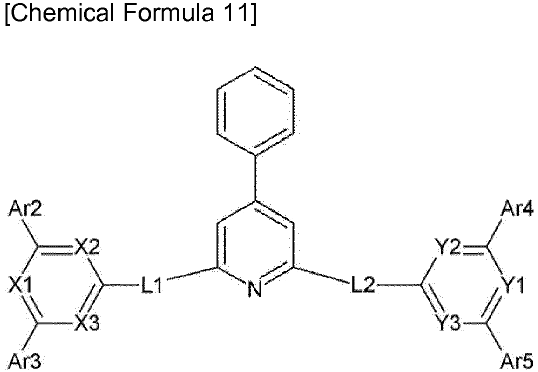

In Chemical Formula 11, Ar2 to Ar5, X1 to X3, Y1 to Y3, L1, and L2 are the same as defined in the following Table 4.

**(Table 4)**

| compound | Ar2 and Ar4 | Ar3 and Ar5 | L1 and L2 | X1 and Y1 | X2 and Y2 | X3 and Y3 |
|---|---|---|---|---|---|---|
| 106 | 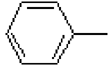 | 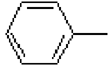 | 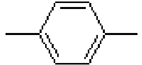 | N | C | C |
| 107 | | | | C | N | C |
| 108 | | | | C | C | N |
| 109 | | | | N | N | C |
| 110 | | | | N | C | N |
| 111 | | | | C | N | N |
| 112 | | | | N | N | N |
| 113 | 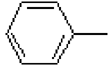 | 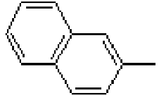 | 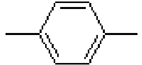 | N | C | C |
| 114 | | | | C | N | C |
| 115 | | | | C | C | N |
| 116 | | | | N | N | C |
| 117 | | | | N | C | N |
| 118 | | | | C | N | N |
| 119 | | | | N | N | N |
| 120 | 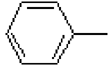 | 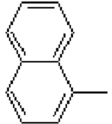 | 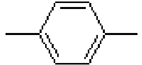 | N | C | C |
| 121 | | | | C | N | C |
| 122 | | | | C | C | N |
| 123 | | | | N | N | C |
| 124 | | | | N | C | N |
| 125 | | | | C | N | N |
| 126 | | | | N | N | N |
| 127 | 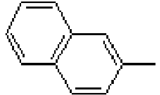 | 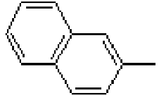 | 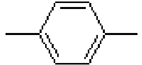 | N | C | C |
| 128 | | | | C | N | C |
| 129 | | | | C | C | N |
| 130 | | | | N | N | C |
| 131 | | | | N | C | N |
| 132 | | | | C | N | N |
| 133 | | | | N | N | N |
| 134 | 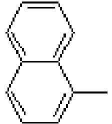 | 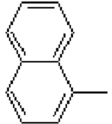 | 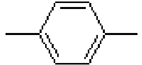 | N | C | C |
| 135 | | | | C | N | C |
| 136 | | | | C | C | N |
| 137 | | | | N | N | C |
| 138 | | | | N | C | N |
| 139 | | | | C | N | N |
| 140 | | | | N | N | N |

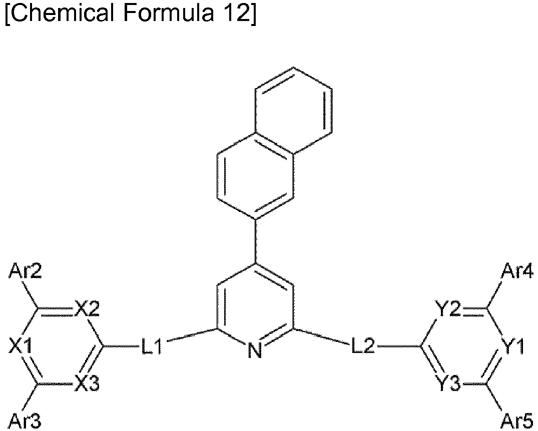

In Chemical Formula 12, Ar2 to Ar5, X1 to X3, Y1 to Y3, L1, and L2 are the same as defined in the following Table 5.

**(Table 5)**

| Compound | Ar2 and Ar4 | Ar3 and Ar5 | L1 and L2 | X1 and Y1 | X2 and Y2 | X3 and Y3 |
|---|---|---|---|---|---|---|
| 141 | 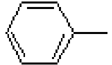 | 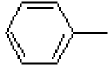 | 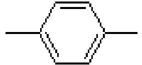 | N | C | C |
| 142 | | | | C | N | C |
| 143 | | | | C | C | N |
| 144 | | | | N | N | C |
| 145 | | | | N | C | N |
| 146 | | | | C | N | N |
| 147 | | | | N | N | N |
| 148 | 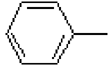 | 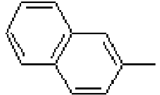 | 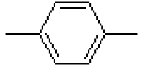 | N | C | C |
| 149 | | | | C | N | C |
| 150 | | | | C | C | N |
| 151 | | | | N | N | C |
| 152 | | | | N | C | N |
| 153 | | | | C | N | N |
| 154 | | | | N | N | N |
| 155 | 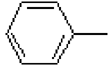 | 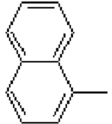 | 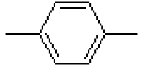 | N | C | C |
| 156 | | | | C | N | C |
| 157 | | | | C | C | N |
| 158 | | | | N | N | CC |
| 159 | | | | N | C | N |
| 160 | | | | C | N | N |
| 161 | | | | N | N | N |
| 162 | 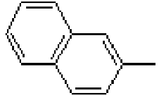 | 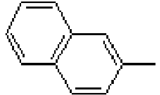 | 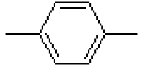 | N | C | C |
| 163 | | | | C | N | C |
| 164 | | | | C | C | N |
| 165 | | | | N | N | C |
| 166 | | | | N | C | N |
| 167 | | | | C | N | N |
| 168 | | | | N | N | N |
| 169 | 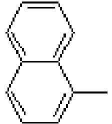 | 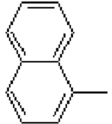 | 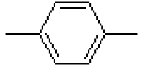 | N | C | C |
| 170 | | | | C | N | C |
| 171 | | | | C | C | N |
| 172 | | | | N | N | C |
| 173 | | | | N | C | N |
| 174 | | | | C | N | N |
| 175 | | | | N | N | N |

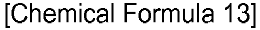

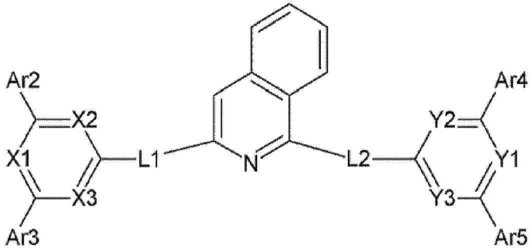

In Chemical Formula 13, Ar2 to Ar5, X1 to X3, Y1 to Y3, L1, and L2 are the same as defined in the following Table 6.

**(Table 6)**

| Compound | Ar2 and Ar4 | Ar3 and Ar5 | L1 and L2 | X1 and Y1 | X2 and Y2 | X3 and Y3 |
|---|---|---|---|---|---|---|
| 176 | 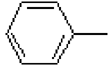 | 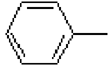 | 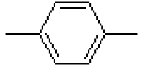 | N | C | C |
| 177 | | | | C | N | C |
| 178 | | | | C | C | N |
| 179 | | | | N | N | C |
| 180 | | | | N | C | N |
| 181 | | | | C | N | N |
| 182 | | | | N | N | N |
| 183 | 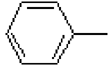 | 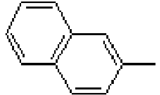 | 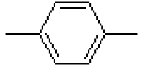 | N | C | C |
| 184 | | | | C | N | C |
| 185 | | | | C | C | N |
| 186 | | | | N | N | C |
| 187 | | | | N | C | N |
| 188 | | | | C | N | N |
| 189 | | | | N | N | N |
| 190 | 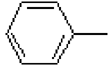 | 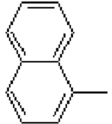 | 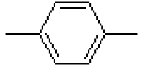 | N | C | C |
| 191 | | | | C | N | C |
| 192 | | | | C | C | N |
| 193 | | | | N | N | C |
| 194 | | | | N | C | N |
| 195 | | | | C | N | N |
| 196 | | | | N | N | N |
| 197 | 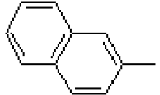 | 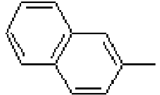 | 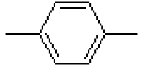 | N | C | C |
| 198 | | | | C | N | C |
| 199 | | | | C | C | N |
| 200 | | | | N | N | C |
| 201 | | | | N | C | N |
| 202 | | | | C | N | N |
| 203 | | | | N | N | N |
| 204 | 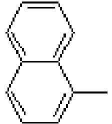 | 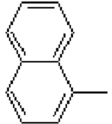 | 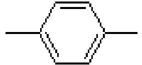 | N | C | C |
| 205 | | | | C | N | C |
| 206 | | | | C | C | N |
| 207 | | | | N | N | C |
| 208 | | | | N | C | N |
| 209 | | | | C | N | N |
| 210 | | | | N | N | N |

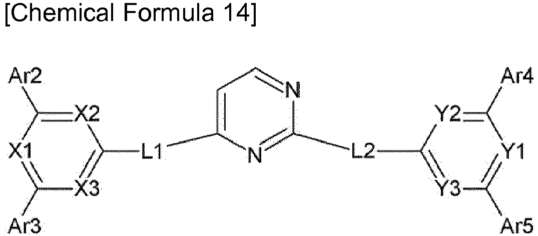

In Chemical Formula 14, Ar2 to Ar5, X1 to X3, Y1 to Y3, L1, and L2 are the same as defined in the following Table 7.

**(Table 7)**

| Compound | Ar2 and Ar4 | Ar3 and Ar5 | L1 and L2 | X1 and Y1 | X2 and Y2 | X3 and Y3 |
|---|---|---|---|---|---|---|
| 211 | 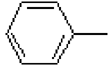 | 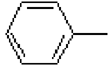 | 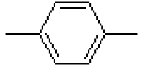 | N | C | C |
| 212 | | | | C | N | C |
| 213 | | | | C | C | N |
| 214 | | | | N | N | C |
| 215 | | | | N | C | N |
| 216 | | | | C | N | N |
| 217 | | | | N | N | N |
| 218 | 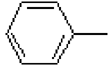 | 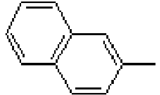 | 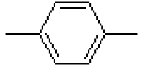 | N | C | C |
| 219 | | | | C | N | C |
| 220 | | | | C | C | N |
| 221 | | | | N | N | C |
| 222 | | | | N | C | N |
| 223 | | | | C | N | N |
| 224 | | | | N | N | N |
| 225 | 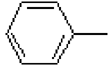 | 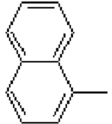 | 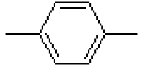 | N | C | C |
| 226 | | | | C | N | C |
| 227 | | | | C | C | N |
| 228 | | | | N | N | C |
| 229 | | | | N | C | N |
| 230 | | | | C | N | N |
| 231 | | | | N | N | N |
| 232 | 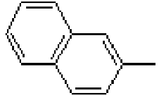 | 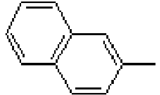 | 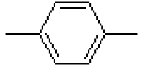 | N | C | C |
| 233 | | | | C | N | C |
| 234 | | | | C | C | N |
| 235 | | | | N | N | C |
| 236 | | | | N | C | N |
| 237 | | | | C | N | N |
| 238 | | | | N | N | N |
| 239 | 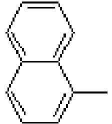 | 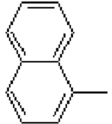 | 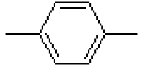 | N | C | C |
| 240 | | | | C | N | C |
| 241 | | | | C | C | N |
| 242 | | | | N | N | C |
| 243 | | | | N | C | N |
| 244 | | | | C | N | N |
| 245 | | | | N | N | N |

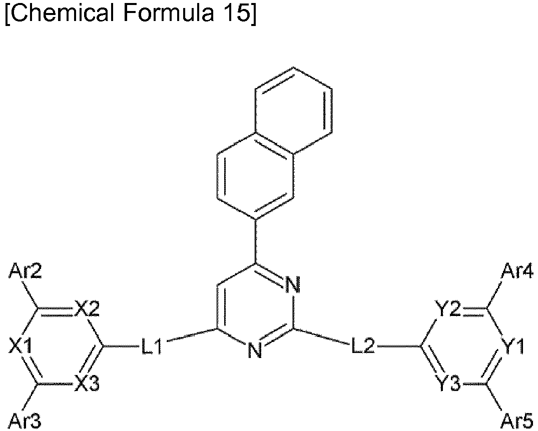

In Chemical Formula 15, Ar2 to Ar5, X1 to X3, Y1 to Y3, L1, and L2 are the same as defined in the following Table 8.

**(Table 8)**

| Compound | Ar2 and Ar4 | Ar3 and Ar5 | L1 and L2 | X1 and Y1 | X2 and Y2 | X3 and Y3 |
|---|---|---|---|---|---|---|
| 246 | 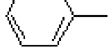 | 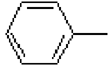 | 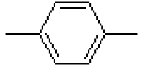 | N | C | C |
| 247 | | | | C | N | C |
| 248 | | | | C | C | N |
| 249 | | | | N | N | C |
| 250 | | | | N | C | N |
| 251 | | | | C | N | N |
| 252 | | | | N | N | N |
| 253 | 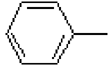 | 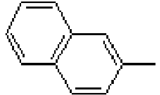 | 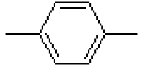 | N | C | C |
| 254 | | | | C | N | C |
| 255 | | | | C | C | N |
| 256 | | | | N | N | C |
| 257 | | | | N | C | N |
| 258 | | | | C | N | N |
| 259 | | | | N | N | N |
| 260 | 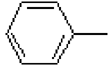 | 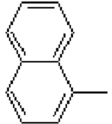 | 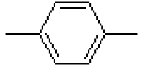 | N | C | C |
| 261 | | | | C | N | C |
| 262 | | | | C | C | N |
| 263 | | | | N | N | C |
| 264 | | | | N | C | N |
| 265 | | | | C | N | N |
| 266 | | | | N | N | N |
| 267 | 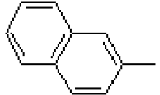 | 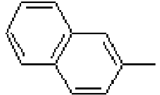 | 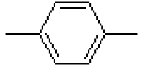 | N | C | C |
| 268 | | | | C | N | C |
| 269 | | | | C | C | N |
| 270 | | | | N | N | C |
| 271 | | | | N | C | N |
| 272 | | | | C | N | N |
| 273 | | | | N | N | N |
| 274 | 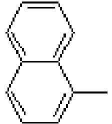 | 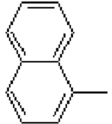 | 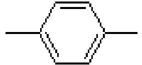 | N | C | C |
| 275 | | | | C | N | C |
| 276 | | | | C | C | N |
| 277 | | | | N | N | C |
| 278 | | | | N | C | N |
| 279 | | | | C | N | N |
| 280 | | | | N | N | N |

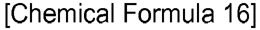

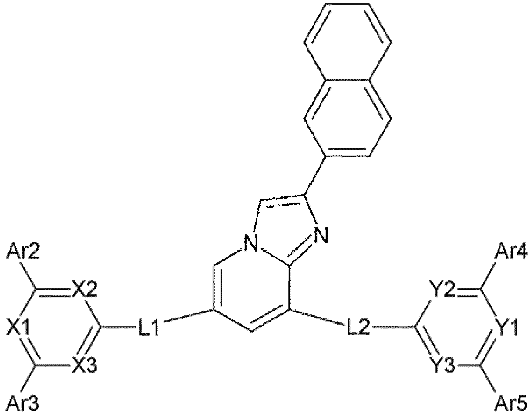

In Chemical Formula 16, Ar2 to Ar5, X1 to X3, Y1 to Y3, L1, and L2 are the same as defined in the following Table 9.

**(Table 9)**

| Compound | Ar2 and Ar4 | Ar3 and Ar5 | L1 and L2 | X1 and Y1 | X2 and Y2 | X3 and Y3 |
|---|---|---|---|---|---|---|
| 281 | 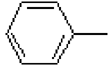 | 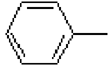 | 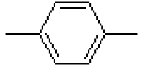 | N | C | C |
| 282 | | | | C | N | C |
| 283 | | | | C | C | N |
| 284 | | | | N | N | C |
| 285 | | | | N | C | N |
| 286 | | | | C | N | N |
| 287 | | | | N | N | N |
| 288 | 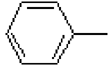 | 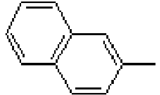 | 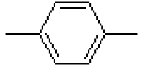 | N | C | C |
| 289 | | | | C | N | C |
| 290 | | | | C | C | N |
| 291 | | | | N | N | C |
| 292 | | | | N | C | N |
| 293 | | | | C | N | N |
| 294 | | | | N | N | N |
| 295 | 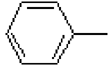 | 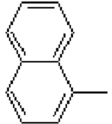 | 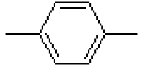 | N | C | C |
| 296 | | | | C | N | C |
| 297 | | | | C | C | N |
| 298 | | | | N | N | C |
| 299 | | | | N | C | N |
| 300 | | | | C | N | N |
| 301 | | | | N | N | N |
| 302 | 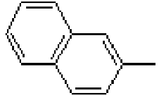 | 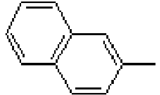 | 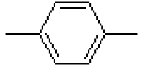 | N | C | C |
| 303 | | | | C | N | C |
| 304 | | | | C | C | N |
| 305 | | | | N | N | C |
| 306 | | | | N | C | N |
| 307 | | | | C | N | N |
| 308 | | | | N | N | N |
| 309 | 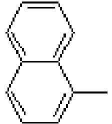 | 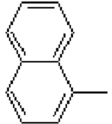 | 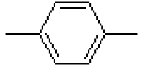 | N | C | C |
| 310 | | | | C | N | C |
| 311 | | | | C | C | N |
| 312 | | | | N | N | C |
| 313 | | | | N | C | N |
| 314 | | | | C | N | N |
| 315 | | | | N | N | N |

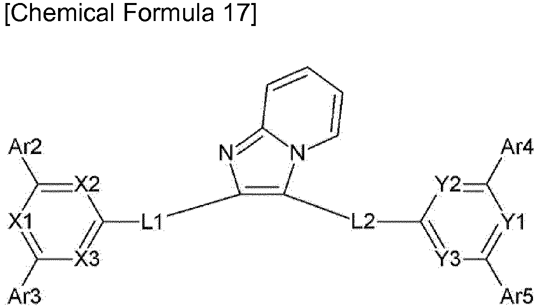

In Chemical Formula 17, Ar2 to Ar5, X1 to X3, Y1 to Y3, L1, and L2 are the same as defined in the following Table 10.

**(Table 10)**

| compound | Ar2 and Ar4 | Ar3 and Ar5 | L1 and L2 | X1 and Y1 | X2 and Y2 | X3 and Y3 |
|---|---|---|---|---|---|---|
| 316 | 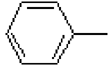 | 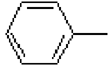 | 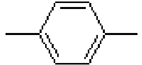 | N | C | C |
| 317 | | | | C | N | C |
| 318 | | | | C | C | N |
| 319 | | | | N | N | C |
| 320 | | | | N | C | N |
| 321 | | | | C | N | N |
| 322 | | | | N | N | N |
| 323 | 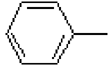 | 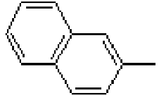 | 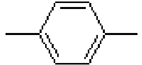 | N | C | C |
| 324 | | | | C | N | C |
| 325 | | | | C | C | N |
| 326 | | | | N | N | C |
| 327 | | | | N | C | N |
| 328 | | | | C | N | N |
| 329 | | | | N | N | N |
| 330 | 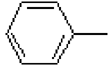 | 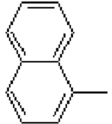 | 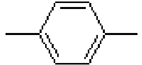 | N | C | C |
| 331 | | | | C | N | C |
| 332 | | | | C | C | N |
| 333 | | | | N | N | C |
| 334 | | | | N | C | N |
| 335 | | | | C | N | N |
| 336 | | | | N | N | N |
| 337 | 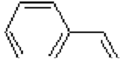 | 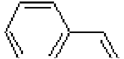 | 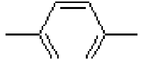 | N | C | C |
| 338 | | | | C | N | C |
| 339 | | | | C | C | N |
| 340 | | | | N | N | C |
| 341 | | | | N | C | N |
| 342 | | | | C | N | N |
| 343 | | | | N | N | N |
| 344 | 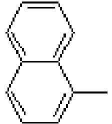 | 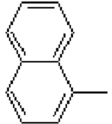 | 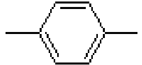 | N | C | C |
| 345 | | | | C | N | C |
| 346 | | | | C | C | N |
| 347 | | | | N | N | C |
| 348 | | | | N | C | N |
| 349 | | | | C | N | N |
| 350 | | | | N | N | N |

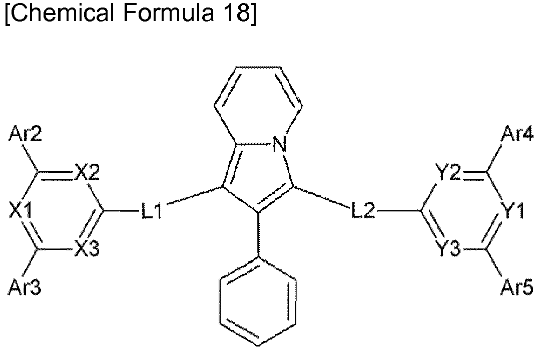

In Chemical Formula 18, Ar2 to Ar5, X1 to X3, Y1 to Y3, L1, and L2 are the same as defined in the following Table 11.

**(Table 11)**

| Compound | Ar2 and Ar4 | Ar3 and Ar5 | L1 and L2 | X1 and Y1 | X2 and Y2 | X3 and Y3 |
|---|---|---|---|---|---|---|
| 351 | 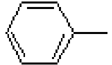 | 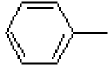 | 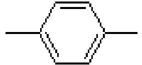 | N | C | C |
| 352 | | | | C | N | C |
| 353 | | | | C | C | N |
| 354 | | | | N | N | C |
| 355 | | | | N | C | N |
| 356 | | | | C | N | N |
| 357 | | | | N | N | N |
| 358 | 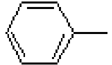 | 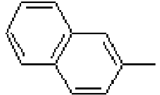 | 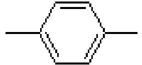 | N | C | C |
| 359 | | | | C | N | C |
| 360 | | | | C | C | N |
| 361 | | | | N | N | C |
| 362 | | | | N | C | N |
| 363 | | | | C | N | N |
| 364 | | | | N | N | N |
| 365 | 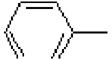 | 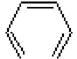 | 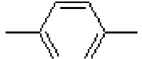 | N | C | C |
| 366 | | | | C | N | C |
| 367 | | | | C | C | N |
| 368 | | | | N | N | C |
| 369 | | | | N | C | N |
| 370 | | | | C | N | N |
| 371 | | | | N | N | N |
| 372 | 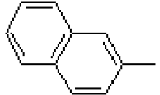 | 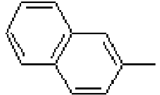 | 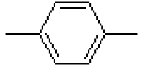 | N | C | C |
| 373 | | | | C | N | C |
| 374 | | | | C | C | N |
| 375 | | | | N | N | C |
| 376 | | | | N | C | N |
| 377 | | | | C | N | N |
| 378 | | | | N | N | N |
| 379 | 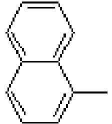 | 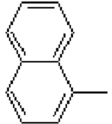 | 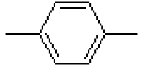 | N | C | C |
| 380 | | | | C | N | C |
| 381 | | | | C | C | N |
| 382 | | | | N | N | C |
| 383 | | | | N | C | N |
| 384 | | | | C | N | N |
| 385 | | | | N | N | N |

The compound for an organic photoelectric device including the above compound has a glass transition temperature of higher than or equal to 110°C or and a thermal decomposition temperature of higher than or equal to 400°C, so as to improve thermal stability. Thereby, an organic photoelectric device having a high efficiency may be realized.

The compound for an organic photoelectric device including the above compound may play a role for emitting light or injecting and/or transporting electrons, and it may act as a light emitting host together with a suitable dopant. The compound for an organic photoelectric device may be applied as a phosphorescent or fluorescent host material, a blue light emitting dopant material, or an electron transport material.

Since the compound for an organic photoelectric device according to one embodiment is used for an organic thin layer, it may improve the life-span characteristic, efficiency characteristic, electrochemical stability, and thermal stability of an organic photoelectric device and decrease the driving voltage.

Therefore, according to another embodiment, an organic photoelectric device is provided that includes the compound for an organic photoelectric device. The organic photoelectric device may include an organic photoelectric device, an organic solar cell, an organic transistor, an organic photosensitive drum, an organic memory device, or the like. For example, the compound for an organic photoelectric device according to one embodiment may be included in an electrode or an electrode buffer layer in the organic solar cell to improve the quantum efficiency, and it may be used as an electrode material for a gate electrode, a source-drain electrode, or the like in the organic transistor.

Hereinafter, a detailed description relating to the organic photoelectric device will be provided.

According to another embodiment of the present invention, the organic photoelectric device includes an anode, a cathode, and at least one organic thin layer interposed between the anode and the cathode, wherein the at least one organic thin layer may provide an organic photoelectric device including the compound for an organic photoelectric device according to one embodiment.

The organic thin layer that may include the compound for an organic photoelectric device may include a layer selected from the group consisting of an emission layer, a hole transport layer (HTL), a hole injection layer (HIL), an electron transport layer (ETL), an electron injection layer (EIL), a hole blocking film, and a combination thereof. The at least one layer includes the compound for an organic photoelectric device according to one embodiment. Particularly, the electron transport layer (ETL) or the electron injection layer (EIL) may include the compound for an organic photoelectric device according to one embodiment. In addition, when the compound for an organic photoelectric device is included in the emission layer, the compound for an organic photoelectric device may be included as a phosphorescent or fluorescent host, and particularly, as a fluorescent blue dopant material.

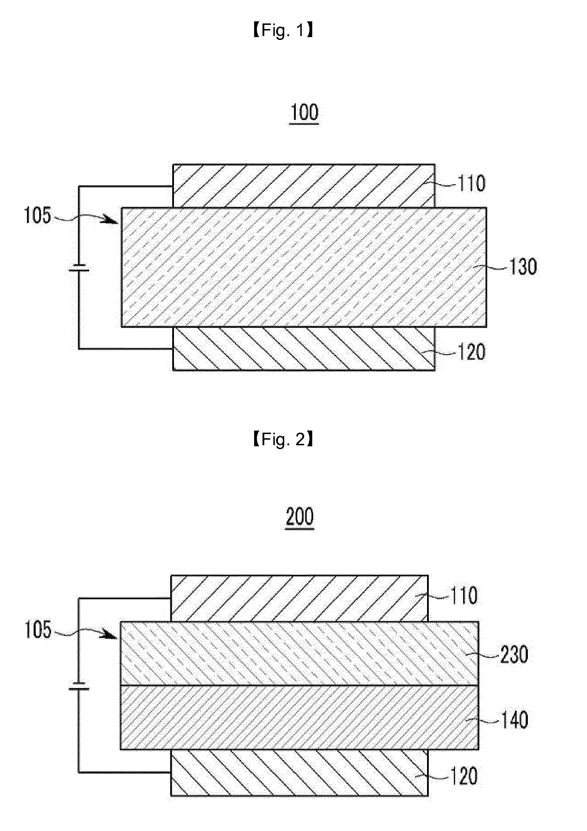

FIGS. 1 to 5 are cross-sectional views showing an organic photoelectric device including the compound for an organic photoelectric device according to one embodiment of the present invention.

Referring to FIGS. 1 to 5, organic photoelectric devices 100, 200, 300, 400, and 500 according to one embodiment include at least one organic thin layer 105 interposed between an anode 120 and a cathode 110.

The anode 120 includes an anode material laving a large work function to help hole injection into an organic thin layer. The anode material includes: a metal such as nickel, platinum, vanadium, chromium, copper, zinc, and gold, or alloys thereof; a metal oxide such as zinc oxide, indium oxide, indium tin oxide (ITO), and indium zinc oxide (IZO); a combined metal and oxide such as ZnO:Al or SnO₂:Sb; or a conductive polymer such as poly(3-methylthiophene), poly[3,4-(ethylene-1,2-dioxy)thiophene] (PEDT), polypyrrole, and polyaniline, but is not limited thereto. It is preferable to include a transparent electrode including indium tin oxide (ITO) as an anode.

The cathode 110 includes a cathode material having a small work function to help electron injection into an organic thin layer. The cathode material includes: a metal such as magnesium, calcium, sodium, potassium, titanium, indium, yttrium, lithium, gadolinium, aluminum, silver, tin, and lead, or alloys thereof; or a multi-layered material such as LiF/Al, Liq/Al, LiO₂/Al, LiF/Ca, LiF/Al, and BaF₂/Ca, but is not limited thereto. It is preferable to include a metal electrode including aluminum as a cathode.

Referring to FIG. 1, the organic photoelectric device 100 includes an organic thin layer 105 including only an emission layer 130.

Referring to FIG. 2, a double-layered organic photoelectric device 200 includes an organic thin layer 105 including an emission layer 230 including an electron transport layer (ETL), and a hole transport layer (HTL) 140. As shown in FIG. 2, the organic thin layer 105 includes a double layer of the emission layer 230 and hole transport layer (HTL) 140. Referring to FIG. 2, a double-layered organic photoelectric device 200 includes an organic thin layer 105 including an emission layer 230 including an electron transport layer (ETL), and a hole transport layer (HTL) 140.

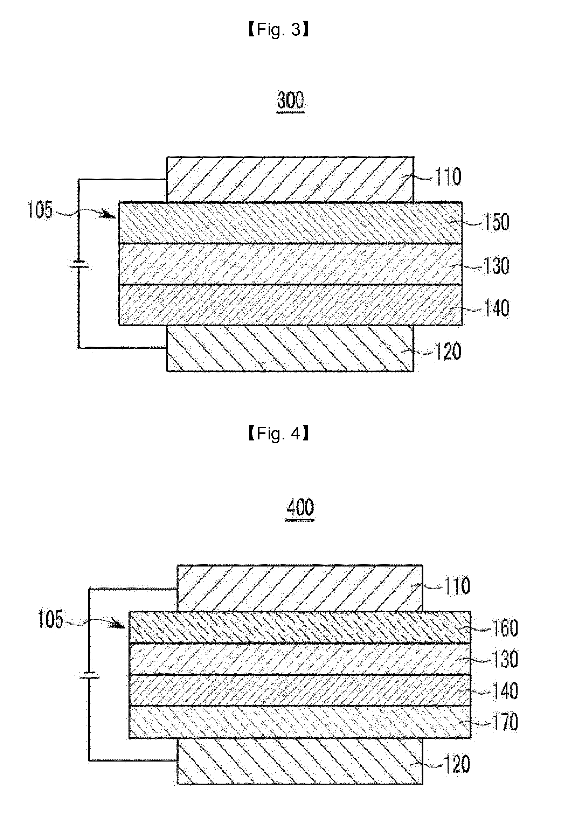

Referring to FIG. 3, a three-layered organic photoelectric device 300 includes an organic thin layer 105 including an electron transport layer (ETL) 150, an emission layer 130, and a hole transport layer (HTL) 140. The emission layer 130 is independently installed, and layers having an excellent electron transporting property or an excellent hole transporting property are separately stacked.

As shown in FIG. 4, a four-layered organic photoelectric device 400 includes an organic thin layer 105 including an electron injection layer (EIL) 160, an emission layer 130, a hole transport layer (HTL) 140, and a hole injection layer (HIL) 170 for binding with the cathode of ITO.

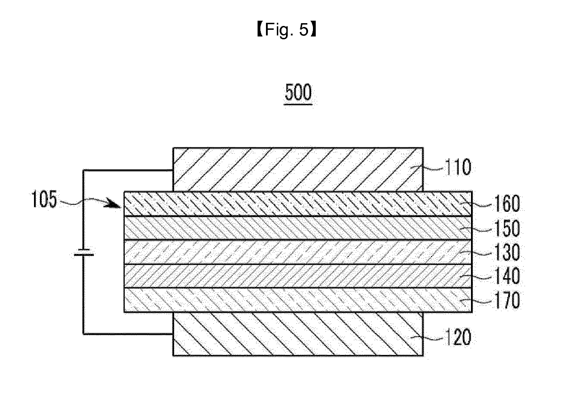

As shown in FIG. 5, a five layered organic photoelectric device 500 includes an organic thin layer 105 including an electron transport layer (ETL) 150, an emission layer 130, a hole transport layer (HTL) 140, and a hole injection layer (HIL) 170, and further includes an electron injection layer (EIL) 160 to achieve a low voltage.

In FIGS. 1 to 5, the organic thin layer 105 including at least one selected from the group consisting of an electron transport layer (ETL) 150, an electron injection layer (EIL) 160, an emission layer 130 and 230, a hole transport layer (HTL) 140, a hole injection layer (HIL) 170, and combinations thereof includes a compound for an organic photoelectric device. The compound for the organic photoelectric device may be used for an electron transport layer (ETL) 150 including the electron transport layer (ETL) 150 or electron injection layer (EIL) 160. When it is used for the electron transport layer (ETL), it is possible to provide an organic photoelectric device having a more simple structure because it does not require an additional hole blocking layer (not shown).

Furthermore, when the compound for an organic photoelectric device is included in the emission layers 130 and 230, the material for the organic photoelectric device may be included as a phosphorescent or fluorescent host or a fluorescent blue dopant.

The organic photoelectric device may be fabricated by: forming an anode on a substrate; forming an organic thin layer in accordance with a dry coating method such as evaporation, sputtering, plasma plating, and ion plating or a wet coating method such as spin coating, dipping, and flow coating; and providing a cathode thereon.

Another embodiment of the present invention provides a display device including the organic photoelectric device according to the above embodiment.

Hereinafter, the embodiments are illustrated in more detail with reference to examples. However, the following are exemplary embodiments and are not limiting.

### (Preparation of Compound for Organic photoelectric device)

### Example 1: Synthesis of Compound 246

The compound 246 as an example of the present invention was synthesized according to Reaction Scheme 1.

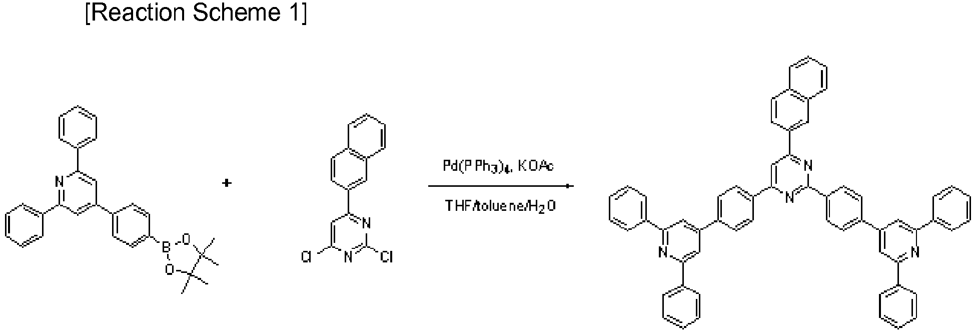

g (25 mmol) of 2,4-dichloro-6-(naphthalen-7-yl)pyrimidine, 24.3 g (56mmol) of 4-(4-(4,4,5,5-tetramethyl-1,3,2-dioxaborolan-2-yl)phenyl)-2,6-diphenyl pyridine, and 1.5g (1.3mmol) of tetrakis-(triphenylphosphine)palladium were suspended in a mixed solvent of 210 ml of tetrahydrofuran and 140 mL of toluene, and a solution prepared by dissolving 14.1g (100mmol) of potassium carbonate in 140mL of water was added thereto. The mixture was heated and refluxed for 12 hours. The liquid reactant was separated into two layers, and the organic layer thereof was cleaned with a sodium chloride saturated aqueous solution dried with anhydrous sodium sulfate. The organic solvent therein was distilled and removed under a reduced pressure, and the residue was recrystallized with toluene. Then, the precipitate was separated with a filter and cleaned with toluene, obtaining 16.7g of a compound (yield: 80.3%).

(Calculation value : 816.99 / Measurement value : MS[M+1] 816)

### Example 2: Synthesis of Compound 248

The compound 248 as an example of the present invention was synthesized according to the following Reaction Scheme 2.

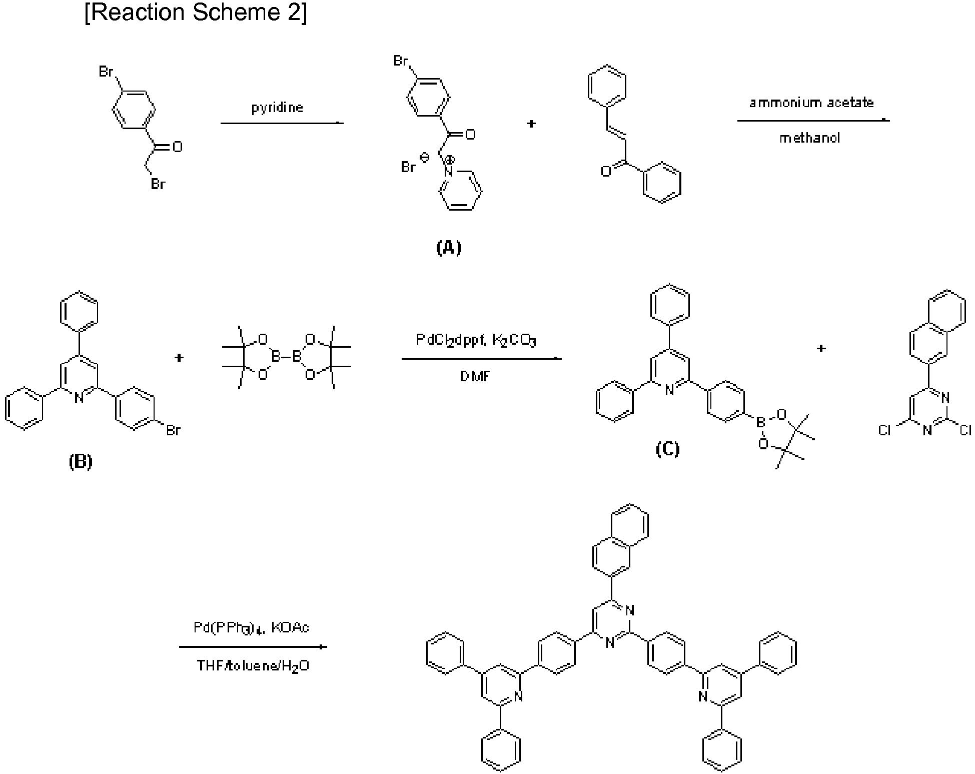

### First step; Synthesis of Intermediate Product (A)

100 g (360 mmol) of 4-bromophenacyl bromide was slowly put into 1000 mL of pyridine, and the mixture was agitated at room temperature for 1 hour. The precipitated solid was filtered and cleaned with diethyl ether, obtaining 127.4 g of an intermediate product A (yield : 99 %).

### Second step; Synthesis of Intermediate Product (B)

185.2g (86.4 mmol) of the intermediate product A, 90 g (43.2 mmol) of trans chalcone, and 333 g (432 mmol) of ammonium acetate was suspended in 1200 mL of methanol, and the mixture was heated and refluxed for 12 hours. After cooling down the reactant, the precipitated solid was filtered and clean with methanol, obtaining 88.4 g of an intermediate product (B) (yield: 53 %).

### Third step: Synthesis of Intermediate Product (C)

130 g (337 mmol) of the intermediate product (B), 102.7 g (404.4 mmol) of bis(pinacolato)diboron, 6.9 g (8.4 mmol) of [1,1'-bis(diphenylphosphino)ferrocene]dichloropalladium (II), and 99.2 g (1011 mmol) of potassium acetate were suspended in 650 mL of dimethylformamide. The suspended reactant was agitated at 80°C for 12 hours. After cooling the reactant, the reactant was poured in distilled water to precipitate a solid. The solid was filtered and separated. The filtered solid was recrystallized with ethylacetate/hexane, obtaining 88.4 g of an intermediate product (C) (yield: 53%).

### Fourth step: Synthesis of Compound 248

2.5 g (9.1 mmol) of 2,4-dichloro-6-(naphthalen-7-yl)pyrimidine, 8.7 g (20 mmol) of the intermediate product (C), and 0.5 g (0.5 mmol) of tetrakis-(triphenylphosphine)palladium were suspended in a mixed solvent of 75 mL of tetrahydrofuran and 50 mL of toluene, and a solution prepared by dissolving 5g (36.4 mmol) of potassium carbonate in 140 mL of water was added thereto. The mixture was heated and refluxed for 12 hours. The liquid reactant was separated into two layers, and the organic layer thereof was cleaned with a sodium chloride saturated aqueous solution and dried with anhydrous sodium sulfate. Then, an organic solvent therein was removed under a reduced pressure, and its residue was recrystallized for precipitation with toluene. The precipitate was filtered and cleaned with toluene, obtaining 6.2g of a compound (yield: 83.5%).

(Calculation value: 816.99 / Measurement value: MS[M+1] 816)

### Example 3: Synthesis of Compound 283

The compound 283 as an exampleof the present invention was synthesized according to the following Reaction Scheme 3.

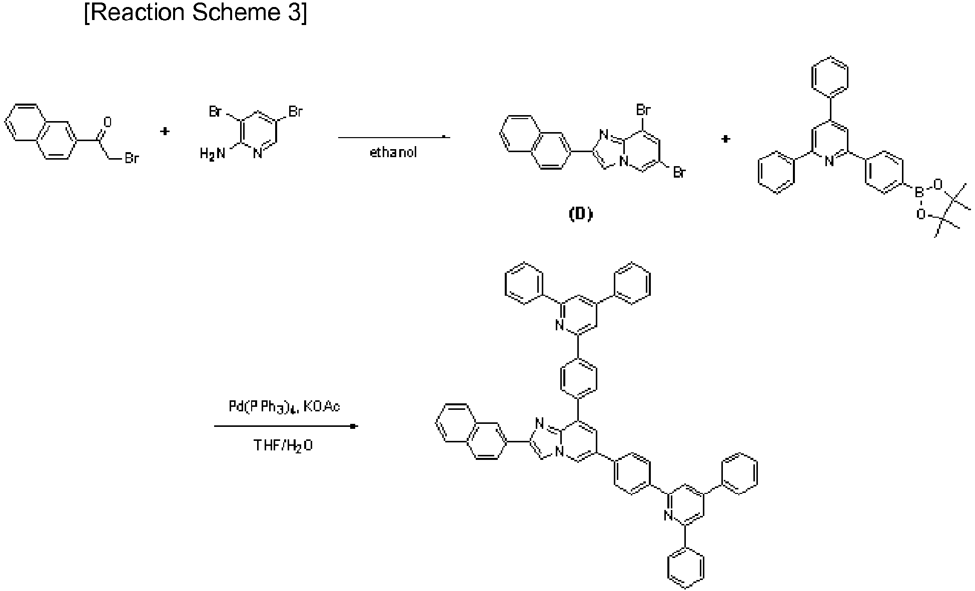

### First step; Synthesis of Intermediate Product (D)

24.9 g (100 mmol) of 2-bromo acetyl naphthalene and 25.2 g (100 ml) of 2-amino-3,5-dibromopyridine were suspended in 300 mL of ethanol. The suspension solution was heated and refluxed for 12 hours. After cooling down the reactant, the precipitated solid was filtered and cleaned with ethanol, obtaining 26.8 g of an intermediate product (D) (yield : 66 %).

### Second step: Synthesis of Compound 283

3.5 g (8.7 mmol) of the intermediate product (D), 9.4 g (21.7 mmol) of the compound (C), and 0.5g (0.44 mmol) of tetrakis-(triphenylphosphine)palladium were suspended in 400 mL of tetrahydrofuran, and a solution prepared by dissolving 4.8 g (34.8 mmol) of potassium carbonate in 200 mL of water. The mixture was heated and refluxed for 12 hours. The liquid reactant was separated into two layers, and an organic layer thereof was cleaned with a sodium chloride saturated aqueous solution and dried with anhydrous sodium sulfate. Then, an organic solvent was distilled and removed under a reduced pressure, and its residue was recrystallized with tetrahydrofuran/methanol. The precipitate was filtered and separated and then, cleaned with methanol, obtaining 6.1g of a compound (yield: 82%).

(Calculation value: 855.03 / Measurement value: MS[M+1] 855)

### Example 4: Synthesis of Compound 318

The compound 318 as an exampleof the present invention was synthesized according to the following Reaction Scheme 4.

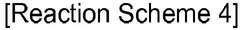

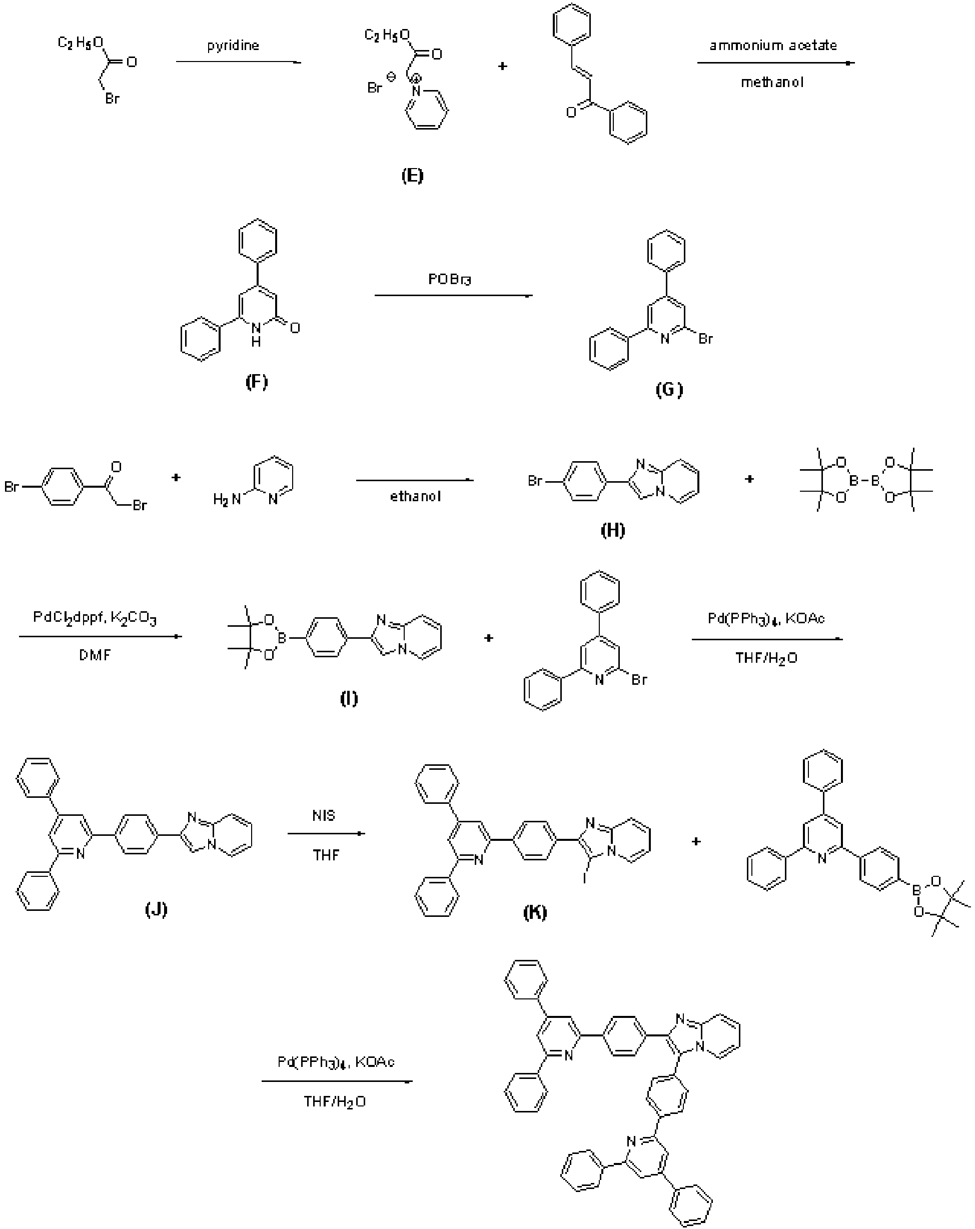

### First step; Synthesis of Intermediate Product (E)

50 mL (451 mmol) of ethylbromoacetate was slowly put into 700 mL of pyridine. The mixture was agitated at room temperature for 2 hours. The precipitated solid therein was filtered and separated and cleaned with diethyl ether, obtaining 105 g of an intermediate product (E) (yield : 94 %).

### Second step; Synthesis of intermediate product (F)

42.5 g (172.9 mmol) of the intermediate product (E), 30 g (144 mmol) of transchalcone, and 111 g (1440 mmol) of ammonium acetate were suspended in 600 mL of methanol, and the mixture was heated and refluxed for 12 hours. After cooling down the reactant, the precipitated solid therein was filtered and separated and cleaned with methanol, obtaining 831.2 g of an intermediate product (F) (yield : 87 %).

### Third step; Synthesis of Intermediate Product (G)

20 g (80.9 mmol) of the intermediate product (F) and 25 g (87.2 mmol) of phosphoric acid tribromide were agitated together at 130°C for 2 hours. The liquid reactant was cooled down to room temperature, and water was poured for neutralization thereto. A solid produced therein was filtered. The obtained solid was cleaned with methanol, obtaining 17.3 g of an intermediate product (G) (yield : 68%).

### Fourth step; Synthesis of Intermediate Product (H)

50 g (180 mmol) of 4-bromophenacyl bromide and 20.3 g (220 ml) of 2-aminopyridine were suspended in 300 mL of ethanol. The suspension reactant was heated and refluxed for 12 hours. After cooling down the reactant , the precipitated solid produced therein was filtered and separated and cleaned with ethanol, obtaining 36.6 g of an intermediate product (H) (yield : 74 %).

### Fifth step; Synthesis of Intermediate Product (I)

27.3 g (100 mmol) of the intermediate product (H), 30.5 g (120 mmol) of bis(pinacolato)diboron, 0.82g (1mmol) of [1,1'-bis(diphenylphosphino)ferrocene]dichloropalladium (II), and 29.4g (300 mmol) of potassium acetate were suspended in 250 mL of dimethylformamide and agitated together at 80°C for 12 hours. After cooling down the reaction solution, it was poured down to distilled water for precipitation. The precipitated solid was filtered and separated. The filtered solid was recrystallized with ethylacetate/hexane, obtaining 22.6 g of an intermediate product (I) (yield : 70 %).

### Sixth step; Synthesis of Intermediate Product (J)

9.1 g (25.8 mmol) of the intermediate product (I), 8 g (21.7 mmol) of the compound (G), and 0.9 g (0.8 mmol) of tetrakis-(triphenylphosphine)palladium were suspended in 200 mL of tetrahydrofuran, and a solution prepared by dissolving 7.1 g (51.6 mmol) of potassium carbonate in 100 mL of water. The mixture was heated and refluxed for 12 hours. The liquid reactant was separated into two layers. The organic layer therein was cleaned with a sodium chloride saturated aqueous solution and dried with anhydrous sodium sulfate. Then, an organic solvent therein was distilled and removed under a reduced pressure, and its residue was separated with a silica gel column, obtaining 3.35g of a compound (J) (yield: 30%).

### Seventh step; Synthesis of Intermediate Product (K)

3.3 g (7.8 mmol) of the intermediate product (J) and 2.1 g (9.4 mmol) of N-iodosuccinimide were dissolved in 150 mL of tetrahydrofuran, and the solution was agitated at 50°C for 12 hours. After cooling down the reactant, its solvent was distilled under a reduced pressure. The obtained solid was dissolved in dichloromethane, and the solution was reprecipitated in methanol and filtered, obtaining 4.3 g of a compound (K) (yield: 100 %).

### Eighth step: Synthesis of Compound 318

4.3 g (7.8 mmol) of the intermediate product (K), 4.1 g (9.4 mmol) of the compound (C), and 0.27 g (0.23 mmol) of tetrakis-(triphenylphosphine)palladium were suspended in 400 mL of tetrahydrofuran, and a solution prepared by dissolving 2.2 g (17.2 mmol) of potassium carbonate in 200 mL of water was added thereto. The mixture was heated and refluxed for 12 hours. The liquid reactant was separated into two layers, and the organic layer therein was cleaned with a sodium chloride saturated aqueous solution and dried with anhydrous sodium sulfate. Then, an organic solvent therein was distilled and removed under a reduced pressure, and its residue was separated with a silica gel column, obtaining 5.36 g of a compound (yield: 93%).

(Calculation value: 728.88 / Measurement value: MS[M+1] 728)

### Example 5: Synthesis of Compound 177

The compound 177 as an example of the present invention was synthesized according to the following Reaction Scheme 5.

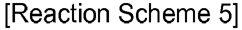

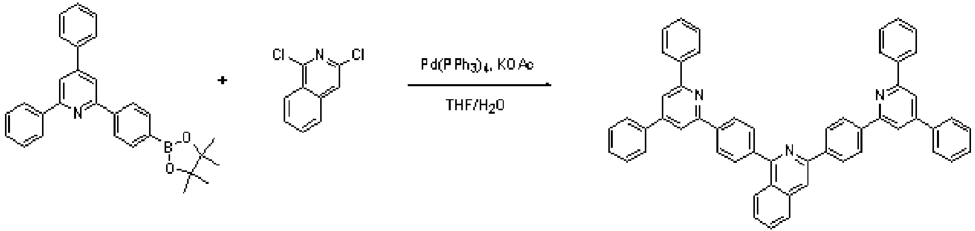

3 g (15.1 mmol) of 1,3-dichloroisoquinoline, 16.4 g (37.8 mmol) of the compound (C), and 0.9 g (0.76 mmol) of tetrakis-(triphenylphosphine)palladium were suspended in 180 mL of tetrahydrofuran, and a solution prepared by dissolving 8.3 g (60.4 mmol) of potassium carbonate in 90 mL of water was added thereto. The mixture was heated and refluxed for 12 hours. The liquid reactant was separated into two layers, and an organic layer therein was cleaned with a sodium chloride-saturated aqueous solution and dried with anhydrous sodium sulfate. Then, an organic solvent therein was distilled under a reduced pressure, and its residue was recrystallized with chlorobenzene, obtaining 5.4g of a compound (yield: 48%).

(Calculation value: 739.90 / Measurement value: MS[M+1] 739)

A glass transition temperature and a thermal decomposition temperature of the synthesized materials were measured using DSC and TGA.

### (Fabrication of Organic Photoelectric Device)

### Example 6

An organic photoelectric device was fabricated using 1000 A-thick ITO as an anode and 1000 A-thick aluminum (Al) as a cathode.

In particular, the anode was prepared cutting an ITO glass substrate having a sheet resistance of 15 Ω/cm² into a size of 50 mm x 50 mm x 0.7 mm and cleaning it in acetone, isopropylalcohol, and pure water, respectively for 5 minutes and with UV ozone for 30 minutes.

Next, N1,N1'-(biphenyl-4,4'-diyl)bis(N1-(naphthalen-2-yl)-N4,N4-diphenylbenzene-1,4-diamine) was deposited to be 65 nm thick as a hole injection layer (HIL) on the glass substrate, and N,N'-di(1-naphthyl)-N,N'-diphenylbenzidine was deposited to be 40 nm thick as a hole transport layer (HTL).

Then, 5% of N,N,N',N'-tetrakis(3,4-dimethylphenyl)chrysene-6,12-diamine and 95 % of 9-(3-(naphthalen-1-yl)phenyl)-10-(naphthalen-2-yl)anthracene were deposited to be 25 nm thick as an emission layer on the hole transport layer (HTL).

Then, the compound according to Example 1 was deposited to be 30 nm thick on the emission layer as an electron transport layer (ETL).

On the electron transport layer (ETL), Liq was vacuum-deposited to be 0.5 nm thick on the electron injection layer (EIL), and Al was vacuum-deposited to be 100 nm thick, forming a Liq/Al electrode.

### Example 7

An organic photoelectric device was fabricated according to the same method as Example 6 except for using the compound according to Example 2 instead of the compound according to Example 1 to form an electron transport layer (ETL).

### Example 8

An organic photoelectric device was fabricated according to the same method as Example 6 except for using the compound according to Example 4 instead of the compound according to Example 1 to form an electron transport layer (ETL).

### Comparative Example 1

An organic photoelectric device was fabricated according to the same method as Example 6 except for using 35 nm-thick tris(8-hydroxy quinolato)aluminum (Alq₃) instead of the compound according to Example 1 to form an electron transport layer (ETL).

### Performance measurement of Organic Photoelectric Device

### Experimental Examples

### Measurement method

Each of the obtained organic photoelectric devices according to Examples 6 to 8 and Comparative Example 1 was measured for luminance change, current density change depending upon the voltage, and luminous efficiency. The specific method was as follows.

### 1) Measurement of Current Density Change Depending on Voltage Change

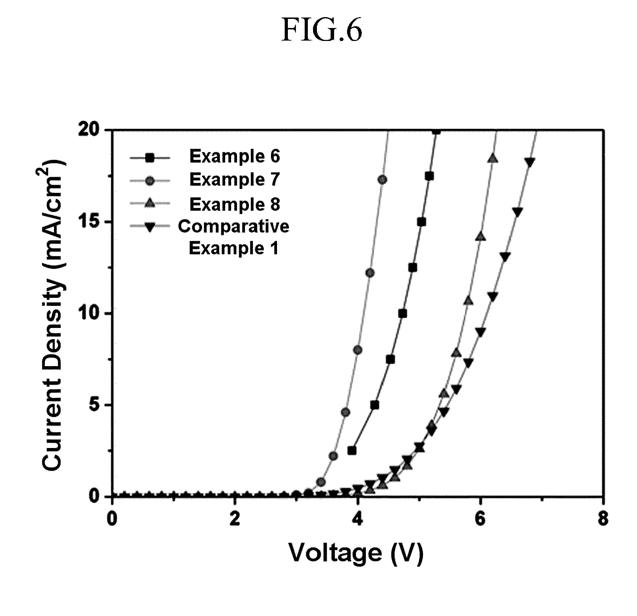

The obtained organic photoelectric devices were measured for current values flowing in the unit devices while increasing the voltages using a current-voltage meter (Keithley 2400), and the measured current values were divided by an area to provide the results. The results are shown in FIG. 6.

### 2) Measurement of Luminance Change Depending on Voltage Change

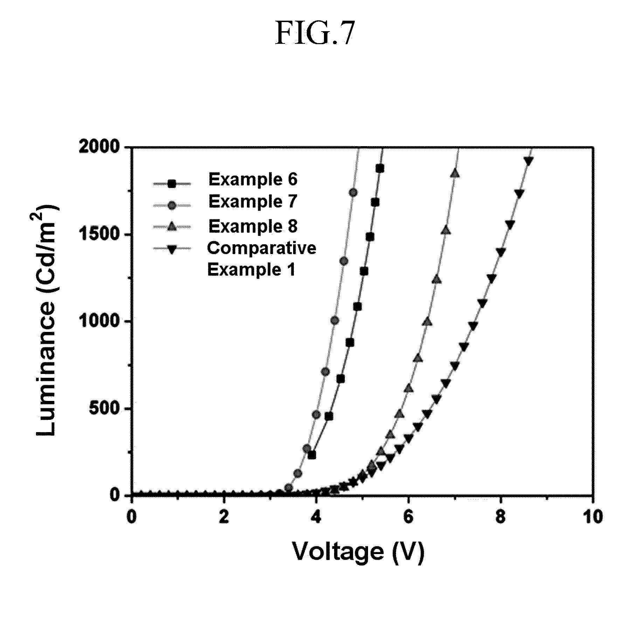

The obtained organic photoelectric devices were measured for luminance using a luminance meter (Minolta Cs-000A) while increasing the voltage. The results are shown in FIG. 7.

### 3) Measurement of Luminous Efficiency and Electric Power Efficiency

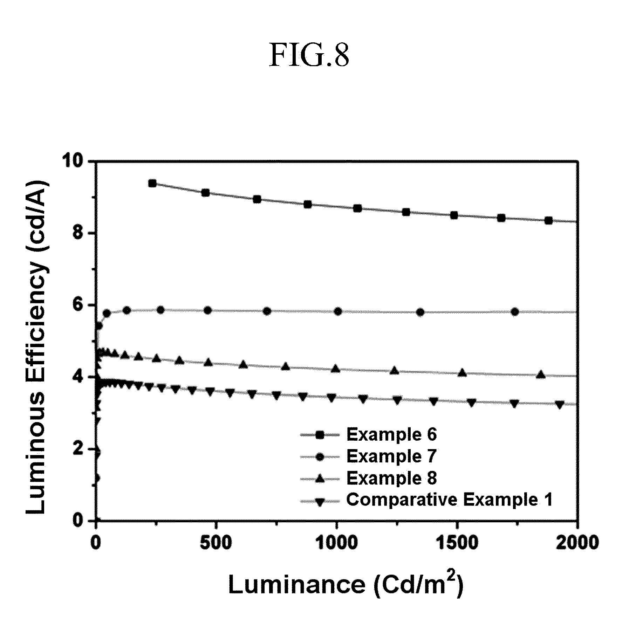

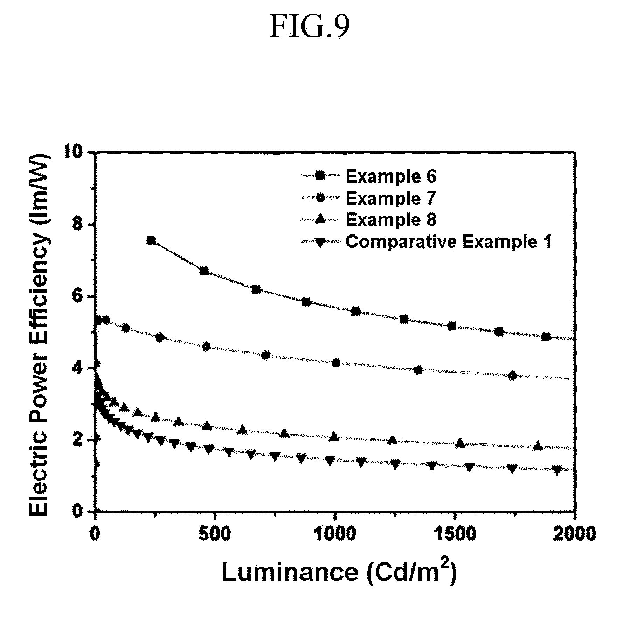

Current efficiency and electric power efficiency were calculated by using luminance and current density from 1) and 2) and voltage. The results are shown in FIGS. 8 and 9, and Table 12.

### 4) Measurement of Life-span

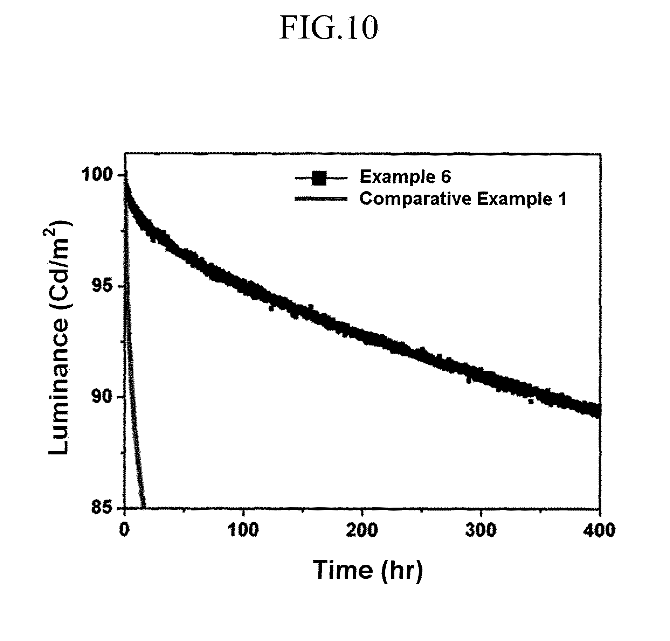

The organic photoelectric devices according to Example 6 and Comparative Example 1 were compared about life-span by decreasing luminance depending on time with a reference to reference luminance of 1000 cd/m². The results are shown in FIG. 10.

### Results

As shown in FIG. 6, the organic photoelectric devices according to Examples 6 to 7 had remarkably better current density than the one according to Comparative Example 1 at the same voltage. A larger current density difference was shown at a higher high voltage.

In addition, as shown in FIG. 7, the organic photoelectric devices according to Examples 6 to 7 had remarkably better light emitting luminance than the one according to Comparative Example 1 at the same voltage. A larger light-emitting luminance difference was shown at a higher voltage.

As shown in FIGS. 8 and 9 and the following Table 12, the organic photoelectric devices according to Examples 6 and 7 had remarkably excellent luminous efficiency and electric power efficiency compared with the one according to Comparative Example 1.

**(Table 12)**

| | Luminance at 500 cd/m² | | |
|---|---|---|---|
| | Driving voltage (V) | Luminous efficiency (cd/A) | Electric power efficiency (Im/W) |
| Example 6 | 4.3 | 9.1 | 6.7 |
| Example 7 | 4 | 5.85 | 4.59 |
| Example 8 | 5.8 | 4.39 | 2.38 |
| Comparative Example 1 | 6.6 | 3.58 | 1.70 |

As shown in FIG. 10, the organic photoelectric device according to Example 6 had greater than or equal to 20 times longer life-span than the one according to Comparative Example 1.

Organic photoelectric devices including the compounds according to embodiments disclosed in the invention showed a low driving voltage and high luminous efficiency and thus an increased life span of a device, which was confirmed by device operation experiments.

While this invention has been described in connection with what is presently considered to be practical exemplary embodiments, it is to be understood that the invention is not limited to the disclosed embodiments, but, on the contrary, is intended to cover various modifications and equivalent arrangements included within the spirit and scope of the appended claims. Therefore, the aforementioned embodiments should be understood to be exemplary but not limiting the present invention in any way.

## Claims

1. A compound for an organic photoelectric device represented by the following Chemical Formula 1: 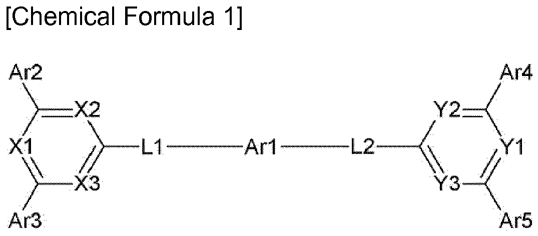 wherein, in Chemical Formula 1,
Ar1 is a substituted or unsubstituted C2 to C30 heteroaryl group,
Ar2 to Ar5 are the same or different and independently a substituted or unsubstituted C6 to C30 aryl group,
L1 and L2 are the same or different and independently a substituted or unsubstituted C6 to C30 arylene group,
X1 to X3 are the same or different and independently a heteroatom or C-H, provided that at least one of X1 to X3 is a heteroatom, and
Y1 to Y3 are the same or different and independently a heteroatom or C-H, provided that at least one of Y1 to Y3 is a heteroatom.

2. The compound of claim 1, wherein Ar1 is selected from the group consisting of a substituted or unsubstituted imidazolylene group, a substituted or unsubstituted thiazolylene group, a substituted or unsubstituted oxazolylene group, a substituted or unsubstituted oxadiazolylene group, a substituted or unsubstituted triazolylene group, a substituted or unsubstituted pyrimidinylene group, a substituted or unsubstituted pyridinylene group, a substituted or unsubstituted pyradazinylene group, a substituted or unsubstituted quinolinylene group, a substituted or unsubstituted isoquinolinylene group, a substituted or unsubstituted acridinylene group, a substituted or unsubstituted imidazopyridinylene group, and a substituted or unsubstituted imidazopyrimidinylene group.

3. The compound of claim 1, wherein Ar1 is a substituent selected from the group consisting of the following Chemical Formulae 2 to 7: 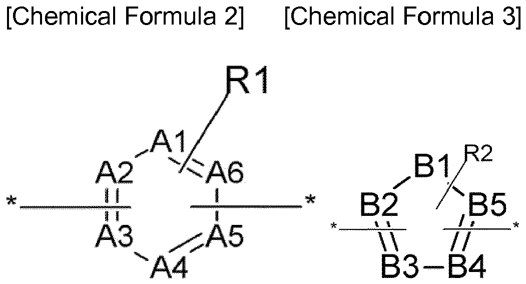 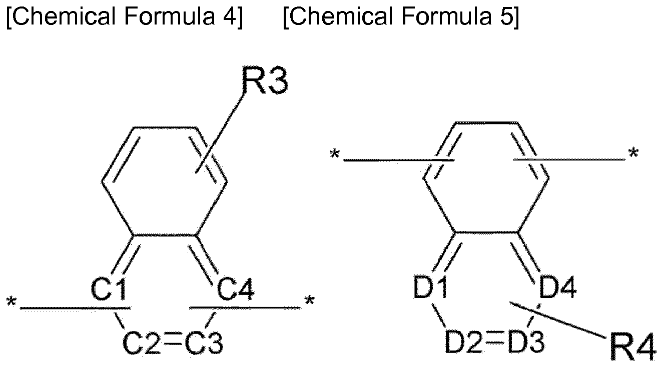 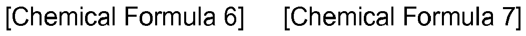 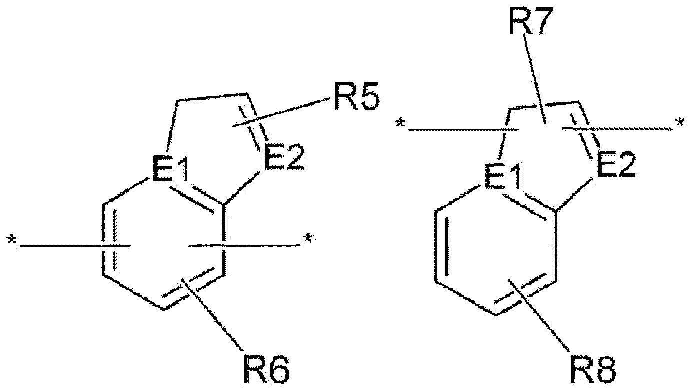 wherein, in Chemical Formulae 2 to 7,
A1 to A6 are the same or different and independently a heteroatom or C-H, provided that at least one of A1 to A6 is a heteroatom,
B1 to B5 are the same or different and independently a heteroatom or C-H, provided that at least one of B1 to B5 is a heteroatom,
C1 to C4 are the same or different and independently a heteroatom or C-H, provided that at least one of C1 to C4 is a heteroatom,
D1 to D4 are the same or different and independently a heteroatom or C-H, provided that at least one of D1 to D4 is a heteroatom,
E1 and E2 are the same or different and independently a heteroatom or C-H, provided that at least one of E1 and E2 is a heteroatom, and
R1 to R7 are the same or different and independently selected from the group consisting of hydrogen, a substituted or unsubstituted C1 to C10 alkyl group, a substituted or unsubstituted C5 to C30 aryl group, and a substituted or unsubstituted C2 to C30 heteroaryl group.

4. The compound of claim 1, wherein Ar2 to Ar5 are the same or different and are independently selected from the group consisting of a substituted or unsubstituted phenyl group, a substituted or unsubstituted naphthyl group, a substituted or unsubstituted anthracenyl group, a substituted or unsubstituted phenanthrenyl group, a substituted or unsubstituted pyrenyl group, a substituted or unsubstituted perylenyl group, a substituted or unsubstituted chrysenyl group.

5. The compound of claim 1, wherein L1 and L2 are the same or different and are independently selected from the group consisting of a substituted or unsubstituted phenylene group, a substituted or unsubstituted naphthylene group, a substituted or unsubstituted anthracenylene group, a substituted or unsubstituted phenanthrenylene group, a substituted or unsubstituted pyrenylene group, a substituted or unsubstituted perylenylene group, and a substituted or unsubstituted chrysenylene group.

6. An organic photoelectric device comprising
an anode, a cathode, and at least one or more organic thin layers between the anode and the cathode,
wherein at least one of the organic thin layer comprises the compound for an organic photoelectric device according to one of claims 1 to 5.

7. The organic photoelectric device of claim 6, wherein the organic thin layer is selected from the group consisting of an emission layer, a hole transport layer (HTL), a hole injection layer (HIL), an electron transport layer (ETL), an electron injection layer (EIL), a hole blocking layer, and a combination thereof.

8. The organic photoelectric device of claim 6, wherein the compound for an organic photoelectric device is included in an electron transport layer (ETL) or an electron injection layer (EIL).

9. The organic photoelectric device of claim 6, wherein the compound for an organic photoelectric device is included in an emission layer.

10. The organic photoelectric device of claim 6, wherein the compound for an organic photoelectric device is used as a phosphorescent or fluorescent host material in an emission layer.

11. The organic photoelectric device of claim 6, wherein the compound for an organic photoelectric device is used as a fluorescent blue dopant material in an emission layer.

12. The organic photoelectric device of claim 6, wherein the organic photoelectric device is selected from the group consisting of an organic light emitting diode, an organic solar cell, an organic transistor, an organic photo conductor drum, and an organic memory device.

13. A display device including the organic photoelectric device according to claim 6.
